# EUROPÄISCHE PATENTSCHRIFT

(11) **EP 3 042 447 B1**
(45) Veröffentlichungstag und Bekanntmachung des Hinweises auf die Patenterteilung: **21.04.2021**
(21) Anmeldenummer: 14789979.3
(22) Anmeldetag: 05.09.2014
(51) Int. Cl.: H03M 1/10, H03M 1/12

(54) **MESSVERSTÄRKER MIT HINTERGRUNDJUSTIERUNG UND VERFAHREN DAFÜR**
MEASURING AMPLIFIER WITH BACKGROUND ADJUSTMENT AND METHOD THEREFOR
AMPLIFICATEUR DE MESURE AVEC RÉGLAGE EN ARRIÈRE-PLAN ET PROCÉDÉ ASSOCIÉ

(30) Priorität: 06.09.2013 DE 102013014876
(43) Veröffentlichungstag der Anmeldung: 13.07.2016
(73) Patentinhaber: Hottinger Brüel & Kjaer GmbH, 64293 Darmstadt (DE)
(72) Erfinder: SCHÄCK, Marco M., 63322 Rödermark (DE); KITZING, Herbert, 64289 Darmstadt (DE)
(74) Vertreter: Staudte, Ralph
(86) Internationale Anmeldenummer: PCT/DE2014/000463
(87) Internationale Veröffentlichungsnummer: WO 2015/032382

(56) Entgegenhaltungen:
- US-A1- 2001 010 500
- KENNETH C DYER ET AL: "An Analog Background Calibration Technique for Time-Interleaved Analog-to-Digital Converters", IEEE JOURNAL OF SOLID-STATE CIRCUITS, IEEE SERVICE CENTER, PISCATAWAY, NJ, USA, Bd. 33, Nr. 12, Dezember 1998 (1998-12), XP011060879, ISSN: 0018-9200
- SHAY MAYMON ET AL: "Quantization and compensation in sampled interleaved multi-channel systems", ACOUSTICS SPEECH AND SIGNAL PROCESSING (ICASSP), 2010 IEEE INTERNATIONAL CONFERENCE ON, IEEE, PISCATAWAY, NJ, USA, 14. März 2010 (2010-03-14), Seiten 3622-3625, XP031697832, ISBN: 978-1-4244-4295-9

## Beschreibung

Die vorliegende Erfindung bezieht sich auf einen Messverstärker mit Hintergrundkalibrierung und -justierung sowie auf ein Verfahren zum Durchführen der Hintergrundkalibrierung und -justierung für einen derartigen Messverstärker.

Mit einem Messverstärker werden elektrische Eingangssignale in Messwerte umgesetzt. Dabei kommen Komponenten wie Verstärker, Analog-Digital-Umsetzer, Filter usw. zum Einsatz, mit deren Hilfe die Eingangssignale verstärkt, digitalisiert, gefiltert usw. werden, um verwertbare Messwerte zu erhalten. Die elektrischen Eingangssignale können von einem Messaufnehmer oder mehreren Messaufnehmern geliefert werden. Entsprechend kann ein Messverstärker einen Kanal oder mehrere Kanäle aufweisen.

Die Schaltungen eines Messverstärkers weisen zumeist eine Vielzahl von einzelnen Bauelementen auf, wobei jedes der Bauelemente eine eigene Toleranz hat. Insbesondere bei einem Präzisionsmessverstärker dürfen die Toleranzen nur sehr klein sein. Während die ursprünglichen Toleranzen der Bauelemente sich durch strenge Auswahlverfahren noch gut kontrollieren lassen, kann kaum Einfluss auf das durch Temperatur und Alterung verursachte Driftverhalten der einzelnen Bauelemente genommen werden.

Präzisionsmessverstärker des Anmelders können mit einer Klassengenauigkeit von 5 ppm, d. h. 0,0005 %, am Rande der physikalischen Grenze messen bzw. Eingangssignale in Messwerte umsetzen. Um diese Genauigkeit zu gewährleisten und auch über viele Jahre konstant zu halten, ist eine geräteinterne automatische Kalibrierung und Justierung bzw. Autojustage notwendig. Dabei wird zyklisch mit einem internen Referenzsignal die Drift des Messverstärkers kompensiert und auf diese Weise die hohe Klassengenauigkeit des Messverstärkers über seine Betriebszeit konstant gehalten. Nach der Einlaufphase des Messverstärkers findet bei diesem Vorgang nur noch eine unmerkliche Nachjustierung statt.

Bei früher verwendeten Verfahren werden zyklisch die Messung für einige Zeit unterbrochen und mithilfe von zwei Referenzpunkten (Null- und Endwert) der Nullpunkt und die Verstärkung korrigiert. Im Anschluss kann die Messung wieder fortgesetzt werden. Jedoch sind an dieser Stelle die Filtereinschwingzeiten von Filtern in dem Messverstärker abzuwarten, welche zum Teil erheblich sind. Diese Unterbrechungen des Messbetriebs sind für einen Anwender störend und bei bestimmten Anwendungen nicht vertretbar. Daher ist die Vermeidung derartiger Unterbrechungen wünschenswert.

In der EP 2 056 460 B1 ist ein Verfahren offenbart, mit dem Messwerte eines Messverstärkers korrigiert werden können, ohne den Messbetrieb zu unterbrechen. Dabei wandelt eine erste Verstärkerschaltung ein ihr permanent zugeführtes Eingangssignal kontinuierlich, d. h. ohne jede Unterbrechung, in Messwerte um. Eine zweite Verstärkerschaltung ist parallel zu der ersten Verstärkerschaltung geschaltet. Ihr werden abwechselnd das Eingangssignal, ein Referenzsignal und ein Nullsignal zugeführt. Messwerte der zweiten Verstärkerschaltung werden aufgrund des Referenzsignals und des Nullsignals korrigiert. Daraufhin werden die Differenzen zwischen den korrigierten Messwerten der zweiten Verstärkerschaltung und den nicht korrigierten Messwerten der ersten Verstärkerschaltung bei verschiedenen Pegeln des Eingangssignals ermittelt sowie basierend darauf der Nullpunktfehler und der Verstärkungsfehler bestimmt. Auf der Grundlage der bestimmten Fehler können dann die Messwerte der ersten Verstärkerschaltung korrigiert werden. Auf diese Weise kann kontinuierlich gemessen werden. Der Messbetrieb muss nicht unterbrochen werden.

Mit dem in der EP 2 056 460 B1 beschriebenen Verfahren können der Nullpunkfehler und der Verstärkungsfehler nur optimal bestimmt werden, wenn sich das Eingangssignal signifikant ändert. Ist die Änderung des Eingangssignals quasistatisch, wird zwar der Messwert der ersten Verstärkerschaltung in Summe richtig korrigiert, jedoch nicht was die Aufteilung in Nullpunkt- und Verstärkungsfehler betrifft. Ein Verstärkungsfehler kann immer nur dann bestimmt werden, wenn regelmäßig eine signifikante Eingangssignaländerung auftritt. Tritt eine signifikante Änderung des Eingangssignals auf, weicht der Messwert zunächst durch die unrichtige Bestimmung von Nullpunkt- und Verstärkungsfehler ab. Der Nullpunktfehler und der Verstärkungsfehler werden nach dem Sprung in dem Eingangssignal und ihrer neuen Ermittlung nachgezogen und somit korrigiert. Bis dahin weicht jedoch der Messwert für eine bestimmte Zeit, die von der Implementierung abhängt, ab.

Bei dem in der EP 2 056 460 B1 offenbarten Verfahren kommt es zudem zu einer Fehlerfortpflanzung. Bei diesem Verfahren wird der Messverstärker über eine zusätzliche Verstärkerschaltung indirekt kalibriert. Durch das zweistufige Verfahren - erst wird die zusätzliche zweite Verstärkerschaltung kalibriert, dann daraus der Fehler der eigentlichen ersten Verstärkerschaltung abgeleitet - summieren sich Fehler in jeder Stufe und können somit zu einem größeren Fehler des Kalibrierergebnisses führen.

Das in der EP 2 056 460 B1 beschriebene Verfahren erfordert es ferner auch, dass die erste Verstärkerschaltung und die zweite Verstärkerschaltung über einen möglichst langen Zeitraum parallel Messwerte liefern, um basierend auf den Differenzen dieser Messwerte bei verschiedenen Eingangssignalpegeln den Nullpunkt- und Verstärkungsfehler bzw. die Korrekturwerte für die Messwerte der ersten Verstärkerschaltung bestimmen zu können. Daher wird bei Messverstärkern mit mehreren Kanälen für jede einzelne Verstärkerschaltung eine weitere identisch aufgebaute Verstärkerschaltung benötigt. Für eine Anzahl N von Kanälen werden somit immer 2 x N Verstärkerschaltungen benötigt. Dieser Hardwareaufwand ist bei einem Präzisionsmessverstärker häufig nicht praktikabel. Der Aufbau eines Präzisionsmessverstärkers ist wesentlich komplexer und aufwendiger als der Aufbau eines Messverstärkers für Standardanforderungen. Daher kann aus Platz-und Kostengründen selten die doppelte Anzahl von Verstärkerschaltungen verwendet werden.

In KENNETH C DYER ET AL: "An Analog Background Calibration Technique for Time-Interleaved Analog-to-Digital Converters", IEEE JOURNAL OF SOLID-STATE CIRCUITS, IEEE SERVICE CENTER, PISCATAWAY, NJ, USA, Bd. 33, Nr. 12, Dezember 1998 (1998-12), XP011060879, ISSN: 0018-9200 ist eine Kalibrierung von M parallelen und zeitversetzt mit einem Eingangssignal beaufschlagten A/D-Kanälen beschrieben. Für die Kalibrierung werden M+1 A/D-Wandler und ein zusätzlicher Referenz-A/D-Wandler benötigt. Jeweils einer der M+1 A/D-Wandler wird ausgewählt, aus dem A/D-Wandlungsbetrieb herausgenommen und mithilfe eines Kalibrierungssignals und des Referenz-A/D-Wandlers so kalibriert, dass er die gleiche Verstärkung und den gleichen Nullpunkt sowie den gleichen Abtastzeitpunkt wie der Referenz-A/D-Wandler aufweist. Anschließend wird der ausgewählte A/D-Wandler wieder in den A/D-Wandlungsbetrieb integriert und ein anderer der M+1 A/D-Wandler für die Kalibrierung selektiert. Somit stehen sowohl der A/D-Wandler, der gerade kalibriert wird, vorübergehend als auch der Referenz-A/D-Wandler dauerhaft nicht für den A/D-Wandlungsbetrieb zur Verfügung. Zudem kann ein für die Kalibrierung genutztes langsames digitales Filter eine lange Filtereinschwingzeit erfordern.

In der US 2001/010500 A1 ist ebenfalls eine Kalibrierung von A/D-Wandlern beschrieben. Dabei kann zwischen zwei parallel geschalteten A/D-Wandlern umgeschaltet werden, wobei einer der A/D-Wandler ein Funktionssignal und der andere ein Referenzsignal erhält. Das von dem A/D-Wandler, der mit dem Referenzsignal beaufschlagt wird, ausgegebene Digitalsignal wird in einer diesem nachgeschalteten Kalibrierungseinrichtung zum Trainieren einer Tabelle verwendet. Ein für die Kalibrierung genutztes langsames digitales Filter kann eine lange Filtereinschwingzeit erfordern.

Es ist die Aufgabe der Erfindung, ein verbessertes Verfahren zum unterbrechungsfreien Kalibrieren und Justieren eines Messverstärkers sowie einen entsprechenden Messverstärker bereitzustellen, bei denen alle oder zumindest ein Teil der vorstehend erörterten Nachteile nicht auftreten.

Diese Aufgabe wird mit dem Verfahren nach dem unabhängigen Anspruch 1 und dem Messverstärker nach dem unabhängigen Anspruch 8 gelöst. Vorteilhafte Weiterbildungen sind in den abhängigen Ansprüchen angegeben.

Nach Anspruch 1 werden bei einem Verfahren zum unterbrechungsfreien Kalibrieren und Justieren eines Messverstärkers für N Messsignale, der zumindest N+1 Verstärkereinrichtungen, die jeweils eine Verstärkerschaltung, einen Analog-Digital-Umsetzer und eine digitale Signalverarbeitungseinheit mit zumindest einem digitalen Filter aufweisen, aufweist und zum Ausgeben von N Messwerten, die den N Messsignalen entsprechen, eingerichtet ist, die folgenden Schritte ausgeführt, wobei N ≥ 1 gilt und ein Index i von 1 bis N läuft. Einer i-ten Verstärkereinrichtung der zumindest N+1 Verstärkereinrichtungen wird ein i-tes Messsignal der N Messsignale zugeführt. Durch die i-te Verstärkereinrichtung aus dem i-ten Messsignal erzeugte Messwerte werden ausgegeben. Zumindest zwei i-te Referenzsignale werden einer weiteren Verstärkereinrichtung der zumindest N+1 Verstärkereinrichtungen zugeführt. Die weitere Verstärkereinrichtung wird mithilfe der zumindest zwei i-ten Referenzsignale kalibriert, wobei ein Nullpunktfehler und ein Verstärkungsfehler der weiteren Verstärkereinrichtung ermittelt werden. Die weitere Verstärkereinrichtung wird justiert, falls zumindest einer der für sie ermittelten Fehler oberhalb eines vorgegebenen Schwellenwerts für diesen Fehler liegt. Das i-te Messsignal wird der weiteren Verstärkereinrichtung zugeführt. Durch die weitere Verstärkereinrichtung aus dem i-ten Messsignal erzeugte Messwerte werden ausgegeben. Zumindest zwei Referenzsignale werden der i-ten Verstärkereinrichtung zugeführt. Die i-te Verstärkereinrichtung wird mithilfe der ihr zugeführten zumindest zwei Referenzsignale kalibriert, wobei ein Nullpunktfehler und ein Verstärkungsfehler der i-ten Verstärkereinrichtung ermittelt werden. Die i-te Verstärkereinrichtung wird justiert, falls zumindest einer der für sie ermittelten Fehler oberhalb des vorgegebenen Schwellenwerts für diesen Fehler liegt. Nach dem Schritt des Zuführens des i-ten Messsignals zu der weiteren Verstärkereinrichtung und vor dem Schritt des Ausgebens von durch die weitere Verstärkereinrichtung aus dem i-ten Messsignal erzeugten Messwerten wird ein Schritt des Kopierens von Filterkoeffizienten und Zustandsspeichern des zumindest einen digitalen Filters der i-ten Verstärkereinrichtung auf das zumindest eine digitale Filter der weiteren Verstärkereinrichtung ausgeführt. Nach einem Schritt des Zuführens eines bisher einer anderen Verstärkereinrichtung der zumindest N+1 Verstärkereinrichtungen zugeführten anderen Messsignals der N Messsignale zu der i-ten Verstärkereinrichtung und vor einem Schritt des Ausgebens von durch die i-te Verstärkereinrichtung aus dem anderen Messsignal erzeugten Messwerten wird ein Schritt des Kopierens von Filterkoeffizienten und Zustandsspeichern des zumindest einen digitalen Filters der anderen Verstärkereinrichtung auf das zumindest eine digitale Filter der i-ten Verstärkereinrichtung ausgeführt.

Mit dem Kalibrier- und Justierverfahren wird jede Verstärkereinrichtung direkt kalibriert. Es wird dabei jeweils mithilfe von Referenzsignalen, die z. B. einen Nullwert und einen Endwert darstellen können, kalibriert und dadurch sowohl der Nullpunktfehler als auch der Verstärkungsfehler richtig bestimmt. Dies gilt selbst für ein sich quasistatische änderndes Messsignal.

Im Gegensatz zu dem in der EP 2 056 460 B1 beschriebenen Verfahren werden bei der Kalibrierung der Verstärkereinrichtungen die Korrekturwerte jeweils nicht mittels einer indirekten Kalibrierung "erlernt", sondern durch eine direkte Kalibrierung berechnet. Hier kommt es somit nicht zu einer Fehlerfortpflanzung, d. h. es entstehen keine Folgefehler und keine dadurch bedingten Messfehler. Mit anderen Worten entstehen keine Fehler, die sich addieren. Das Kalibrier- und Justierverfahren bringt somit die maximale Genauigkeit, die bislang nur bei einer klassischen Kalibrierung mit Messunterbrechung zu erreichen war. Somit können Unterbrechungen vermieden werden und es kann gleichzeitig den hohen Genauigkeitsanforderungen genüge getan werden, die an einen Präzisionsmessverstärker gestellt werden.

Zudem wird in der Regel nur noch eine zusätzliche Verstärkereinrichtung pro Messverstärker zur Realisierung des Kalibrier- und Justierverfahrens benötigt, d. h. es sind statt 2 x N Verstärkereinrichtungen nur N+1 Verstärkereinrichtungen erforderlich. Dies reduziert bei mehrkanaligen Messverstärkern den Hardwareaufwand, den Platzbedarf, den Energieverbrauch und die Herstellungskosten. Das wirkt sich vor allem bei Präzisionsmessverstärkern aus, da hier für jede Verstärkereinrichtung ein erheblich höherer Schaltungsaufwand notwendig ist.

Bei sehr langsamen digitalen Filtern, welche insbesondere bei Präzisionsmessungen notwendig sind, um die geforderte hohe Auflösung zu erreichen, sind Filtereinschwingzeiten von vielen Sekunden oder sogar Minuten notwendig. Um diese Einschwingzeiten zu eliminieren, werden nicht nur die Filterkoeffizienten, sondern auch die Zustandsspeicher der digitalen Filter einer Ausgangsverstärkereinrichtung auf eine Zielverstärkereinrichtung kopiert. Ab dem nächsten Messwert werden dann die Messwerte der Zielverstärkereinrichtung ausgegeben, d. h. die Messaufgabe der Ausgangsverstärkereinrichtung wird von ihr übernommen. Somit sind die digitalen Filter der Zielverstärkereinrichtung mit den richtigen Werten vorgeladen und die Einschwingzeiten entfallen. Darüber hinaus ist auf diese Weise auch eine Übernahme ohne Sprung im Rauschen möglich, da sowohl die Filterkoeffizienten als auch die Zustandsspeicher der digitalen Filter beider Verstärkereinrichtungen im Zeitpunkt der Übernahme miteinander übereinstimmen.

Nach Anspruch 2 ist die weitere Verstärkereinrichtung eine (N+j)-te Verstärkereinrichtung der zumindest N+1 Verstärkereinrichtungen, wobei j ≥ 1 gilt. Zum Kalibrieren der i-ten Verstärkereinrichtung werden die zumindest zwei i-ten Referenzsignale verwendet. Und nach dem Schritt des Justierens der i-ten Verstärkereinrichtung werden wieder das i-te Messsignal der i-ten Verstärkereinrichtung zugeführt und die durch sie erzeugten Messwerte ausgegeben.

Auf diese Weise wird der Verstärkereinrichtung nach ihrer Kalibrierung wieder das ihr bereits davor zugeführte Messsignal zugeleitet. Bevor dies geschieht, ist sie völlig aus dem Messpfad entfernt und kann daher mit hoher Genauigkeit kalibriert werden. Insbesondere können auch bei einem sich quasistatisch ändernden Messsignal zuverlässig sowohl der Nullpunktfehler als auch der Verstärkungsfehler ermittelt werden.

Nach Anspruch 3 gilt j ≥ 1. Für i = 1 ist die weitere Verstärkereinrichtung eine (N+j)-te Verstärkereinrichtung der zumindest N+1 Verstärkereinrichtungen, zum Kalibrieren der i-ten Verstärkereinrichtung werden zumindest zwei (i+1)-te Referenzsignale verwendet, und nach dem Schritt des Justierens der i-ten Verstärkereinrichtung werden ein bisher einer (i+1)-ten Verstärkereinrichtung der zumindest N+1 Verstärkereinrichtungen zugeführtes Messsignal der N Messsignale der i-ten Verstärkereinrichtung zugeführt und durch die i-te Verstärkereinrichtung aus diesem Messsignal erzeugte Messwerte ausgegeben. Für 1 < i < N ist die weitere Verstärkereinrichtung eine (i-1)-te Verstärkereinrichtung der zumindest N+1 Verstärkereinrichtungen, zum Kalibrieren der i-ten Verstärkereinrichtung werden zumindest zwei (i+1)-te Referenzsignale verwendet, und nach dem Schritt des Justierens der i-ten Verstärkereinrichtung werden ein bisher einer (i+1)-ten Verstärkereinrichtung der zumindest N+1 Verstärkereinrichtungen zugeführtes Messsignal der N Messsignale der i-ten Verstärkereinrichtung zugeführt und durch die i-te Verstärkereinrichtung aus diesem Messsignal erzeugte Messwerte ausgegeben. Für i = N ist die weitere Verstärkereinrichtung eine (i-1)-te Verstärkereinrichtung der zumindest N+1 Verstärkereinrichtungen, zum Kalibrieren der i-ten Verstärkereinrichtung werden zumindest zwei (N+j)-te Referenzsignale verwendet, und nach dem Schritt des Justierens der i-ten Verstärkereinrichtung werden ein bisher der (N+j)-ten Verstärkereinrichtung der zumindest N+1 Verstärkereinrichtungen zugeführtes Messsignal der N Messsignale der i-ten Verstärkereinrichtung zugeführt und durch die i-te Verstärkereinrichtung aus diesem Messsignal erzeugte Messwerte ausgegeben.

Nach einer Kalibrierung muss nicht mehr zurückgeschaltet werden. Dadurch ist es möglich, dass die Verstärkereinrichtungen rotieren können, d. h. nach der Kalibrierung bzw. Justierung einer Verstärkereinrichtung der dafür auf eine weitere Verstärkereinrichtung "verschobene" Kanal dort verbleibt und die gerade kalibrierte Verstärkereinrichtung als Ersatz für eine nächste zu kalibrierende Verstärkereinrichtung dient. Auf diese Weise kann durch eine Halbierung der Anzahl der Kalibriervorgänge das Verfahren beschleunigt werden.

Nach Anspruch 4 weist der Messverstärker zumindest 2 x N Verstärkereinrichtungen auf. Die weitere Verstärkereinrichtung ist eine (i+N)-te Verstärkereinrichtung der zumindest 2 x N Verstärkereinrichtungen. Zum Kalibrieren der i-ten Verstärkereinrichtung werden die zumindest zwei i-ten Referenzsignale verwendet. Und nach dem Schritt des Justierens der i-ten Verstärkereinrichtung werden wieder das i-te Messsignal der i-ten Verstärkereinrichtung zugeführt und die durch sie erzeugten Messwerte ausgegeben.

Hier ist zwar der Hardwareaufwand etwas höher. Dafür kann aber das Kalibrier- und Justierverfahren zum einen auch für Messverstärker mit galvanisch getrennten Kanälen verwendet werden und weiterhin mit hoher Genauigkeit arbeiten. Zum anderen ermöglicht es das Vorhandensein einer zusätzlichen Verstärkereinrichtung für jeden einzelnen Kanal, die Kalibrierung und Justierung für mehrere Kanäle gleichzeitig durchzuführen und so das Kalibrier- und Justierverfahren mit einer höheren Frequenz bzw. einer kürzeren Zykluszeit auszuführen. Dies kann die Genauigkeit noch weiter erhöhen.

Nach Anspruch 5 weisen die Verstärkereinrichtungen des Messverstärkers jeweils zumindest ein Filter auf. Nach dem Schritt des Zuführens des i-ten Messsignals zu der weiteren Verstärkereinrichtung und vor dem Schritt des Ausgebens von durch die weitere Verstärkereinrichtung aus dem i-ten Messsignal erzeugten Messwerten wird gewartet, bis das zumindest eine Filter der weiteren Verstärkereinrichtung eingeschwungen ist. Und nach einem Schritt des Zuführens eines bisher einer anderen Verstärkereinrichtung der zumindest N+1 Verstärkereinrichtungen zugeführten anderen Messsignals der N Messsignale zu der i-ten Verstärkereinrichtung und vor einem Schritt des Ausgebens von durch die i-te Verstärkereinrichtung aus dem anderen Messsignal erzeugten Messwerten wird gewartet, bis das zumindest eine Filter der i-ten Verstärkereinrichtung eingeschwungen ist.

Beim Umschalten auf eine alternative Verstärkereinrichtung und wieder zurück wird jeweils gewartet, bis ein Filter oder mehrere Filter, bei denen es sich um analoge oder digitale Filter handeln kann, der jeweiligen Zielverstärkereinrichtung vollständig eingeschwungen sind. Dadurch ist jeweils eine stoßfreie Übernahme der Messaufgabe einer Ausgangsverstärkereinrichtung durch die Zielverstärkereinrichtung möglich. Es ist lediglich im Rauschen ein Sprung zu sehen, der Mittelwert stimmt aber überein.

Nach Anspruch 6 wird nach dem Schritt des Zuführens des i-ten Messsignals zu der weiteren Verstärkereinrichtung und vor dem Schritt des Ausgebens von durch die weitere Verstärkereinrichtung aus dem i-ten Messsignal erzeugten Messwerten ein Schritt des Korrigierens einer Differenz der Eigenfehler der i-ten Verstärkereinrichtung und der weiteren Verstärkereinrichtung ausgeführt. Und nach einem Schritt des Zuführens eines bisher einer anderen Verstärkereinrichtung der zumindest N+1 Verstärkereinrichtungen zugeführten anderen Messsignals der N Messsignale zu der i-ten Verstärkereinrichtung und vor einem Schritt des Ausgebens von durch die i-te Verstärkereinrichtung aus dem anderen Messsignal erzeugten Messwerten wird ein Schritt des Korrigierens einer Differenz der Eigenfehler der anderen Verstärkereinrichtung und der i-ten Verstärkereinrichtung ausgeführt.

Selbst eine minimale Differenz der Eigenfehler von Ausgangsverstärkereinrichtung und Zielverstärkereinrichtung im Arbeitspunkt wie z. B. der Linearitätsfehler wird noch korrigiert, wodurch das Umschalten auf die jeweils andere Verstärkereinrichtung völlig unmerklich verläuft.

Nach Anspruch 7 werden alle Schritte zyklisch wiederholt, um den Messverstärker in vorgegebenen Zeitabständen automatisch zu kalibrieren und erforderlichenfalls zu justieren.

Durch die zyklische Wiederholung der Schritte des Kalibrier- und Justierverfahrens kann insbesondere bei einem Präzisionsmessverstärker die hohe Klassengenauigkeit des Messverstärkers über seine Betriebszeit konstant gehalten werden.

Nach Anspruch 8 weist ein Messverstärker zum Ausführen eines Verfahrens nach einem der vorhergehenden Ansprüche die folgenden Merkmale auf:
die zumindest N+1 Verstärkereinrichtungen, die jeweils die Verstärkerschaltung, den Analog-Digital-Umsetzer und die digitale Signalverarbeitungseinheit mit dem zumindest einen digitalen Filter aufweisen, zumindest N+1 Schalter, die jeweils einer der N+1 Verstärkereinrichtungen zugeordnet sind, zumindest eine Referenzsignalerzeugungseinrichtung und zumindest eine Auswahleinrichtung. Jede Verstärkereinrichtung der N+1 Verstärkereinrichtungen ist mithilfe von durch die zumindest eine Referenzsignalerzeugungseinrichtung erzeugten Referenzsignalen kalibrierbar und justierbar. Eine Verstärkereinrichtung der zumindest N+1 Verstärkereinrichtungen ist zu jeder der anderen Verstärkereinrichtungen parallel schaltbar, jede Verstärkereinrichtung der zumindest N+1 Verstärkereinrichtungen ist jeweils zu jeder der anderen Verstärkereinrichtungen parallel schaltbar oder jede Verstärkereinrichtung der zumindest N+1 Verstärkereinrichtungen ist zu genau einer anderen Verstärkereinrichtung parallel schaltbar. Die jeweilige Umschaltung ist über entsprechende Schalter der zumindest N+1 Schalter ausführbar. Die zumindest eine Auswahleinrichtung ist zum Ausgeben von N Messwerten, die den N Messsignalen entsprechen, eingerichtet. Der Messverstärker ist zum Kopieren von Filterkoeffizienten und Zustandsspeichern des zumindest einen digitalen Filters einer Ausgangsverstärkereinrichtung der zumindest N+1 Verstärkereinrichtungen, deren Messaufgabe durch eine Zielverstärkereinrichtung der zumindest N+1 Verstärkereinrichtungen übernommen wird, auf das zumindest eine digitale Filter der Zielverstärkereinrichtung nach einem Zuführen eines i-ten Messsignals der N Messsignale zu der Zielverstärkereinrichtung und vor einem Ausgeben von durch die Zielverstärkereinrichtung aus dem i-ten Messsignal erzeugten Messwerten eingerichtet.

Bei dem Messverstärker kann jede Verstärkereinrichtung mithilfe von Referenzsignalen direkt kalibriert werden. Dadurch können selbst für ein sich quasistatisch änderndes Messsignal sowohl der Nullpunktfehler als auch der Verstärkungsfehler richtig bestimmt werden und es kommt auch nicht zu einer Fehlerfortpflanzung. Es ist somit möglich, die maximale Genauigkeit zu erreichen und dennoch Unterbrechungen des Messbetriebs zu vermeiden. Dafür wird in der Regel auch bei einem mehrkanaligen Messverstärker nur eine zusätzliche Verstärkereinrichtung benötigt. Zudem können mit dem Messverstärker die bei sehr langsamen digitalen Filtern erforderlichen Filtereinschwingzeiten von vielen Sekunden oder sogar Minuten eliminiert werden, indem nicht nur die Filterkoeffizienten, sondern auch die Zustandsspeicher der digitalen Filter einer Ausgangsverstärkereinrichtung auf eine Zielverstärkereinrichtung kopiert werden.

Nach Anspruch 9 umfasst ein Messsystem einen Messverstärker nach Anspruch 8 und zumindest einen Messaufnehmer, der zum Zuführen der N Messsignale zu dem Messverstärker eingerichtet ist.

Das Messsystem weist die Vorteile auf, die vorstehend bereits im Zusammenhang mit dem Messverstärker bzw. dem von diesem ausgeführten Kalibrier- und Justierverfahren beschrieben sind.

Die Erfindung wird nachfolgend anhand von Ausführungsbeispielen in Verbindung mit schematischen Zeichnungen näher erläutert. Es zeigen:
- Fig. 1: ein vereinfachtes Blockschaltbild eines Messsystems 101 gemäß einem ersten Ausführungsbeispiel;
- Fig. 2: ein vereinfachtes Blockschaltbild eines Messsystems 201 gemäß einem zweiten Ausführungsbeispiel;
- Fig. 3: ein vereinfachtes Blockschaltbild eines Messsystems 301 gemäß einem dritten Ausführungsbeispiel; und
- Fig. 4: ein Flussdiagramm mit den grundlegenden Schritten eines Verfahrens zum unterbrechungsfreien Kalibrieren und Justieren eines Messverstärkers.

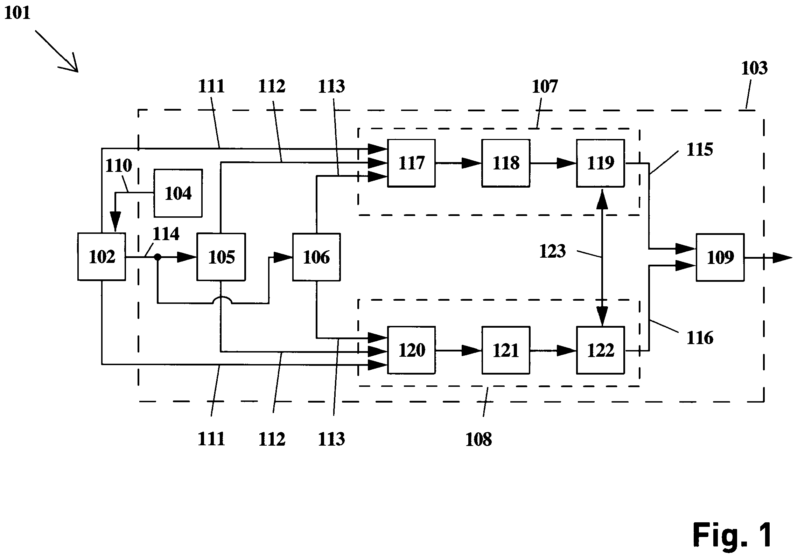

Fig. 1 zeigt das vereinfachte Blockschaltbild des Messsystems 101 gemäß dem ersten Ausführungsbeispiel, in dem der Übersichtlichkeit halber nicht jede Einzelheit dargestellt ist. Das Messsystem 101 umfasst einen Messaufnehmer 102 und einen Messverstärker 103 mit einem Kanal und einer Klassengenauigkeit von z. B. 0,0005 %.

Bei dem Messaufnehmer 102 kann es sich um einen Aufnehmer für eine mechanische Größe wie beispielsweise Kraft, Gewicht, Drehmoment oder Druck, der die Größe z. B. unter Verwendung von in einer Wheatstone'schen Brückenschaltung miteinander verschalteten Dehnungsaufnehmern wie beispielsweise Dehnungsmessstreifen in ein elektrisches Signal umformt, oder auch eine andere Art von Aufnehmer handeln.

Der Messverstärker 103 umfasst eine Spannungsquelle 104, eine erste Referenzsignalerzeugungseinrichtung 105, eine zweite Referenzsignalerzeugungseinrichtung 106, eine zusätzliche Verstärkereinrichtung 107, eine erste Verstärkereinrichtung 108 und eine Auswahleinrichtung 109.

Eine von der Spannungsquelle 104 erzeugte Speisespannung 110 wird dem Messaufnehmer 102 zugeführt. Dieser formt eine gemessene Größe in ein erstes Messsignal 111 um, welches dem Messverstärker 103 bzw. zeitweise der zusätzlichen Verstärkereinrichtung 107 und zeitweise der ersten Verstärkereinrichtung 108 zugeführt wird. Ein von der ersten Referenzsignalerzeugungseinrichtung 105 erzeugtes erstes Referenzsignal 112 und ein von der zweiten Referenzsignalerzeugungseinrichtung 106 erzeugtes zweites Referenzsignal 113 werden ebenfalls zeitweise der zusätzlichen Verstärkereinrichtung 107 und zeitweise der ersten Verstärkereinrichtung 108 zugeführt. Dies ist nachstehend näher erläutert.

Die erste Referenzsignalerzeugungseinrichtung 105 und die zweite Referenzsignalerzeugungseinrichtung 106 werden mit einer von dem Messaufnehmer 102 zurückgeführten Spannung 114 versorgt, um Leitungsverluste berücksichtigen zu können.

Bei der Auswahleinrichtung 109 kann es sich beispielsweise um einen Multiplexer oder eine andere Art von Selektionsschaltung handeln. Mit ihrer Hilfe werden entweder durch die zusätzliche Verstärkereinrichtung 107 aus dem ersten Messsignal 111 erzeugte Messwerte 115 oder durch die erste Verstärkereinrichtung 108 aus dem ersten Messsignal 111 erzeugte Messwerte 116 ausgewählt und ausgegeben, d.h. beispielsweise einer in Fig. 1 nicht dargestellten Ausgabeeinrichtung wie z. B. einer Anzeige zugeführt.

Die zusätzliche Verstärkereinrichtung 107 umfasst eine zusätzliche Verstärkerschaltung 117, einen zusätzlichen Analog-Digital-Umsetzer 118 und eine zusätzliche digitale Signalverarbeitungseinheit 119. Die zusätzliche Verstärkerschaltung 117 weist einen Verstärker auf und kann weitere Elemente wie beispielsweise einen Demodulator und analoge Filter wie z. B. einen Tiefpass umfassen, was in Fig. 1 nicht im Einzelnen dargestellt ist. Die zusätzliche digitale Signalverarbeitungseinheit 119 kann für verschiedene Berechnungen verwendet werden und weist ein digitales Filter oder mehrere digitale Filter auf, wobei in Fig. 1 kein derartiges Filter dargestellt ist.

Die erste Verstärkereinrichtung 108 ist in der gleicher Art und Weise wie die zusätzliche Verstärkereinrichtung 107 aufgebaut und umfasst eine erste Verstärkerschaltung 120, einen ersten Analog-Digital-Umsetzer 121 und eine erste digitale Signalverarbeitungseinheit 122. Die erste Verstärkerschaltung 120 weist einen Verstärker auf und kann weitere Elemente wie beispielsweise einen Demodulator und analoge Filter wie z. B. einen Tiefpass umfassen, was in Fig. 1 nicht im Einzelnen dargestellt ist. Die erste digitale Signalverarbeitungseinheit 122 kann für verschiedene Berechnungen verwendet werden und weist ein digitales Filter oder mehrere digitale Filter auf, wobei in Fig. 1 kein derartiges Filter dargestellt ist.

Bei der zusätzlichen digitalen Signalverarbeitungseinheit 119 und der ersten digitalen Signalverarbeitungseinheit 122 kann es sich beispielsweise um digitale Signalprozessoren handeln.

Die digitalen Filter in der ersten digitalen Signalverarbeitungseinheit 122 und der zusätzlichen digitalen Signalverarbeitungseinheit 119 weisen jeweils Filterkoeffizienten und Zustandsspeicher auf. Dabei können wie nachstehend näher erläutert und in Fig. 1 durch einen Doppelpfeil 123 veranschaulicht die Filterkoeffizienten und Zustandsspeicher bzw. Zustandsspeicherinhalte der digitalen Filter der ersten digitalen Signalverarbeitungseinheit 122 auf die entsprechenden digitalen Filter der zusätzlichen digitalen Signalverarbeitungseinheit 119 kopiert werden und umgekehrt.

Der Ablauf der Hintergrundkalibrierung und -justierung bzw. unterbrechungsfreien Kalibrierung und Justierung stellt sich bei dem Messverstärker 103 gemäß dem ersten Ausführungsbeispiel mit nur einem Kanal und zwei internen Verstärkereinrichtungen 107 und 108 dar wie folgt.

Zunächst befindet sich die erste Verstärkereinrichtung 108 im Messzweig bzw. Messpfad. Ihr wird das erste Messsignal 111 zugeführt und sie verstärkt, digitalisiert und verarbeitet selbiges. Die dadurch aus dem ersten Messsignal 111 erzeugten Messwerte 116 werden über die Auswahleinrichtung 109 ausgegeben.

Nun werden der zusätzlichen Verstärkereinrichtung 107 das erste Referenzsignal 112 von der ersten Referenzsignalerzeugungseinrichtung 105, das z. B. einen Nullwert des ersten Messsignals 111 darstellen kann, und das zweite Referenzsignal 113 von der zweiten Referenzsignalerzeugungseinrichtung 106, das z. B. einen Endwert des ersten Messsignals 111 darstellen kann, zugeführt. Sie wird mit diesen Referenzsignalen kalibriert, wobei ein Nullpunktfehler und ein Verstärkungsfehler der zusätzlichen Verstärkereinrichtung 107 ermittelt werden. Diese Fehlerwerte bzw. entsprechende Korrekturwerte können in der zusätzlichen digitalen Signalverarbeitungseinheit 119 und mit einer höheren Genauigkeit als der Klassengenauigkeit des Messverstärkers 103 berechnet werden. Wenn der Nullpunktfehler oberhalb eines vorgegebenen Schwellenwerts für den Nullpunktfehler liegt und/oder der Verstärkungsfehler oberhalb eines vorgegebenen Schwellenwerts für den Verstärkungsfehler liegt, d. h. einer der Fehlerwerte außerhalb einer vorgegebenen Toleranz liegt, wird die zusätzliche Verstärkereinrichtung 107 basierend auf den ermittelten Werten justiert.

Da die Fehler der zusätzlichen Verstärkereinrichtung 107 jetzt herauskalibriert bzw. -justiert wurden, kann ihr nun über zumindest einen der zusätzlichen Verstärkereinrichtung 107 zugeordneten und in Fig. 1 nicht dargestellten Schalter das erste Messsignal 111 am Eingang parallel zugeschaltet werden, d. h. die zusätzliche Verstärkereinrichtung 107 kann mittels des zumindest einen Schalters parallel zu der ersten Verstärkereinrichtung 108 geschaltet werden und ihr kann das erste Messsignal 111 zugeführt werden. Daraufhin verarbeiten die beiden Verstärkereinrichtungen 107 und 108 nach einem Einschwingen ihrer Filter zeitgleich das identische Nutzsignal. Ist die zusätzliche Verstärkereinrichtung 107 eingeschwungen, d. h. eine Einschwingzeit verstrichen, werden deren Messwerte 115 ausgegeben.

Mit anderen Worten wird der zusätzlichen Verstärkereinrichtung 107 das erste Messsignal 111 zugeführt und sie verstärkt, digitalisiert und verarbeitet selbiges. Nach dem Einschwingen ihrer Filter werden die durch sie aus dem ersten Messsignal 111 erzeugten Messwerte 115 über die Auswahleinrichtung 109 ausgegeben. Dabei verläuft das Umschalten auf die Ausgabe der durch die zusätzliche Verstärkereinrichtung 107 aus dem ersten Messsignal 111 erzeugten Messwerte 115 durch die Auswahleinrichtung 109 so, dass es für einen Anwender nicht wahrnehmbar ist. Eine minimale Differenz der Eigenfehler der beiden Verstärkereinrichtungen 107 und 108 im Arbeitspunkt wie z. B. der Linearitätsfehler wird zusätzlich korrigiert.

Die erste Verstärkereinrichtung 108 ist jetzt nicht mehr an der Messung beteiligt und kann mittels zumindest eines der ersten Verstärkereinrichtung 108 zugeordneten und in Fig. 1 nicht dargestellten Schalters aus dem Messpfad entfernt werden. Sobald dies geschehen ist, kann sie mit zumindest zwei Referenzsignalen, z. B. Null- und Endwert, direkt klassisch kalibriert werden. In diesem Zeitraum übernimmt die zusätzliche Verstärkereinrichtung 107 mit gleich bleibender Genauigkeit die Messaufgabe der ersten Verstärkereinrichtung 108.

Mit anderen Worten werden nun der ersten Verstärkereinrichtung 108 mithilfe des zumindest einen ihr zugeordneten Schalters das erste Referenzsignal 112 von der ersten Referenzsignalerzeugungseinrichtung 105, das z. B. einen Nullwert des ersten Messsignals 111 darstellen kann, und das zweite Referenzsignal 113 von der zweiten Referenzsignalerzeugungseinrichtung 106, das z. B. einen Endwert des ersten Messsignals 111 darstellen kann, zugeführt. Sie wird mit diesen Referenzsignalen kalibriert, wobei ein Nullpunktfehler und ein Verstärkungsfehler der ersten Verstärkereinrichtung 108 ermittelt werden. Diese Fehlerwerte bzw. entsprechende Korrekturwerte können in der ersten digitalen Signalverarbeitungseinheit 122 und mit einer höheren Genauigkeit als der Klassengenauigkeit des Messverstärkers 103 berechnet werden. Wenn der Nullpunktfehler oberhalb eines vorgegebenen Schwellenwerts für den Nullpunktfehler liegt und/oder der Verstärkungsfehler oberhalb eines vorgegebenen Schwellenwerts für den Verstärkungsfehler liegt, d. h. einer der Fehlerwerte außerhalb einer vorgegebenen Toleranz liegt, wird die erste Verstärkereinrichtung 108 basierend auf den ermittelten Werten justiert.

Im Gegensatz zu dem in der EP 2 056 460 B1 beschriebenen Verfahren werden bei der Kalibrierung der beiden Verstärkereinrichtungen 107 und 108 die Korrekturwerte jeweils nicht mittels einer indirekten Kalibrierung "erlernt", sondern durch eine direkte Kalibrierung berechnet. Hier kommt es somit nicht zu einer Fehlerfortpflanzung, d. h. es entstehen keine Folgefehler und keine dadurch bedingten Messfehler.

Nachdem die Fehler der ersten Verstärkereinrichtung 108 herauskalibriert bzw. -justiert wurden, wird diese mittels des ihr zugeordneten zumindest einen Schalters wieder in den Messpfad zurückgeschaltet. Daraufhin werden nach der Einschwingzeit wieder die durch sie aus dem ersten Messsignal 111 erzeugten Messwerte 116 über die Auswahleinrichtung 109 ausgegeben. Dabei verläuft das Umschalten auf die Ausgabe der durch die erste Verstärkereinrichtung 108 aus dem ersten Messsignal 111 erzeugten Messwerte 116 durch die Auswahleinrichtung 109 so, dass es für einen Anwender nicht wahrnehmbar ist. Eine minimale Differenz der Eigenfehler der beiden Verstärkereinrichtungen 107 und 108 im Arbeitspunkt wie z. B. der Linearitätsfehler wird zusätzlich korrigiert.

Ab diesem Zeitpunkt ist die zusätzliche Verstärkereinrichtung 107 nicht mehr an der Messung beteiligt und kann mithilfe des ihr zugeordneten zumindest einen Schalters aus dem Messpfad entfernt werden. Somit ist der ursprüngliche Zustand wieder erreicht.

Dabei müssen die Kalibrierung bzw. Justierung der ersten Verstärkereinrichtung 108 und ihr anschließendes Zurückschalten in den Messpfad nicht unmittelbar nach der Übernahme der Messaufgabe der ersten Verstärkereinrichtung 108 durch die zusätzliche Verstärkereinrichtung 107 ausgeführt werden. Es kann auch damit gewartet werden, bis die nächste turnusmäßige Kalibrierung bzw. Justierung ansteht, und bis dahin die zusätzliche Verstärkereinrichtung 107 im Messpfad verbleiben. Auf diese Weise können die Anzahl der Kalibriervorgänge halbiert und das Verfahren beschleunigt werden.

Nach einem fest definierten Intervall wird der Zyklus erneut angestoßen. Während der verbleibenden Zeit des Intervalls ist die zusätzliche Verstärkereinrichtung 107 oder auch die erste Verstärkereinrichtung 108 nicht in Verwendung. Dies bietet die Möglichkeit, diese gerade nicht verwendete Verstärkereinrichtung bei einem Messverstärker mit mehr als einem Kanal für die Kalibrierüberbrückung bei anderen Kanälen zu verwenden wie nachstehend im Zusammenhang mit dem zweiten und dritten Ausführungsbeispiel erläutert. Sind die Kanäle nicht galvanisch getrennt, wird somit nur noch eine zusätzliche Verstärkereinrichtung pro Messverstärker zur Realisierung des Kalibrier- und Justierverfahrens benötigt. Dies reduziert bei mehrkanaligen Messverstärkern den Hardwareaufwand, den Platzbedarf, den Energieverbrauch und die Herstellungskosten. Das wirkt sich vor allem bei Präzisionsmessverstärkern aus, da hier ein erheblich höherer Schaltungsaufwand für jede Verstärkereinrichtung notwendig ist.

Für die Übernahme der Messaufgabe durch eine Zielverstärkereinrichtung muss jeweils gewährleistet sein, dass die digitalen Filter der Zielverstärkereinrichtung vollständig eingeschwungen sind. Dies ist beim Umschalten in beide Richtungen (zu und von einer zusätzlichen Verstärkereinrichtung) notwendig. Nur dann ist eine stoßfreie Übernahme möglich. Es ist lediglich im Rauschen ein Sprung zu sehen, der Mittelwert stimmt aber überein.

Bei sehr langsamen digitalen Filtern, welche insbesondere bei Präzisionsmessungen notwendig sind, um die sehr hohe Auflösung zu erreichen, sind jedoch Filtereinschwingzeiten von vielen Sekunden oder sogar Minuten notwendig. Um diese Einschwingzeiten zu eliminieren, können nicht nur die Filterkoeffizienten, sondern auch die Zustandsspeicher bzw. Zustandsspeichereinhalte der digitalen Filter einer Ausgangsverstärkereinrichtung auf die Zielverstärkereinrichtung kopiert werden. Ab dem nächsten Messwert werden dann die Messwerte der Zielverstärkereinrichtung ausgegeben, d. h. die Messaufgabe der Ausgangsverstärkereinrichtung von ihr übernommen. Somit sind die digitalen Filter der Zielverstärkereinrichtung mit den richtigen Werten vorgeladen und die Einschwingzeiten entfallen. Darüber hinaus ist auf diese Weise auch eine Übernahme ohne Sprung im Rauschen möglich, da sowohl die Filterkoeffizienten als auch die Zustandsspeicher der digitalen Filter beider Verstärkereinrichtungen im Zeitpunkt der Übernahme miteinander übereinstimmen.

Das Prinzip des Filterumladens ist allgemein und auch bei den nachstehend beschriebenen Ausführungsbeispielen anwendbar. Bei dem vorliegenden ersten Ausführungsbeispiel wird von dem Messverstärker 103 mit nur einem Kanal und zwei Verstärkereinrichtungen 107 und 108 ausgegangen, so dass hier die Filterkoeffizienten und Zustandsspeicher bzw. Zustandsspeicherinhalte der ersten Verstärkereinrichtung 108 auf die zusätzliche Verstärkereinrichtung 107 kopiert werden und umgekehrt. Genauer gesagt werden die Filterkoeffizienten und Zustandsspeicher bzw. Zustandsspeicherinhalte der digitalen Filter der ersten digitalen Signalverarbeitungseinheit 122 auf die entsprechenden digitalen Filter der zusätzlichen digitalen Signalverarbeitungseinheit 119 kopiert und umgekehrt. Auf diese Weise werden die Filter jeweils "einkopiert" statt einzuschwingen. Dadurch muss nicht wie weiter oben beschrieben erst gewartet werden, bis die Einschwingzeit verstrichen ist, wenn auf die jeweils andere Verstärkereinrichtung umgeschaltet wird.

Während in Fig. 1 zwei Referenzsignalerzeugungseinrichtungen dargestellt sind, können auch mehr als zwei Referenzsignalerzeugungseinrichtungen vorgesehen sein oder durch eine einzelne Referenzsignalerzeugungseinrichtung mehrere Referenzsignale erzeugt werden. Es müssen nur jeweils zumindest zwei verschiedene Referenzsignale bzw. Referenzwerte wie beispielsweise Null- und Endwert für die Kalibrierung verfügbar sein, damit sowohl der Nullpunktfehler als auch der Verstärkungsfehler ermittelt werden kann.

Wie vorstehend beschrieben ist jeder der Verstärkereinrichtungen 107 und 108 zumindest ein Schalter zugeordnet, über den der jeweiligen Verstärkereinrichtung das erste Messsignal 111 zugeführt werden kann. Wenn der jeweiligen Verstärkereinrichtung nicht das erste Messsignal 111 zugeführt wird, kann ihr über diesen zumindest einen Schalter das erste Referenzsignal 112 oder das zweite Referenzsignal 113 zugeführt werden. Entsprechend können z. B. ein Schalter für die Zuschaltung des ersten Messsignals 111, ein Schalter für die Zuschaltung des ersten Referenzsignals 112 und ein Schalter für die Zuschaltung des zweiten Referenzsignals 113 vorgesehen sein. Es kann auch ein Multiplexer oder eine andere Art von Selektionsschaltung als Schalter mit mehreren Schaltstellungen vorgesehen sein, um wahlweise das erste Messsignal 111, das erste Referenzsignal 112 oder das zweite Referenzsignal 113 zuzuschalten. Weitere Varianten sind möglich.

Die gleichen Überlegungen gelten für einen Messverstärker mit mehr als einem Kanal wie nachstehend beschrieben. Generell sind bei einem Messverstärker mit N Kanälen und dementsprechend zumindest N+1 Verstärkereinrichtungen auch zumindest N+1 Schalter vorgesehen, die jeweils einer der N+1 Verstärkereinrichtungen zugeordnet sind, um zwischen einem Messsignal oder mehreren Messsignalen und zumindest zwei Referenzsignalen umzuschalten. Dabei sind die Schalter nicht unbedingt als einzelne Bauelemente vorgesehen. Sie können auch auf andere Weise wie z. B. in Form einer integrierten Schaltung realisiert sein.

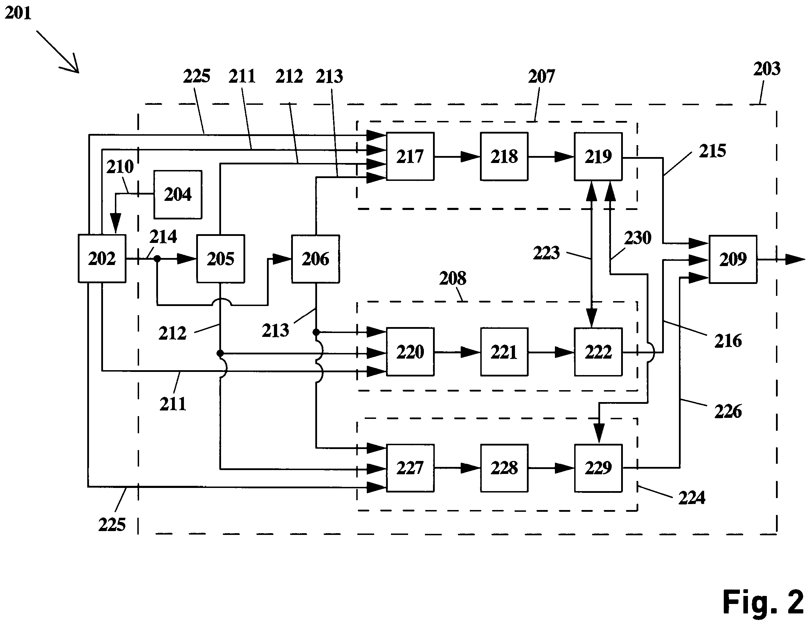

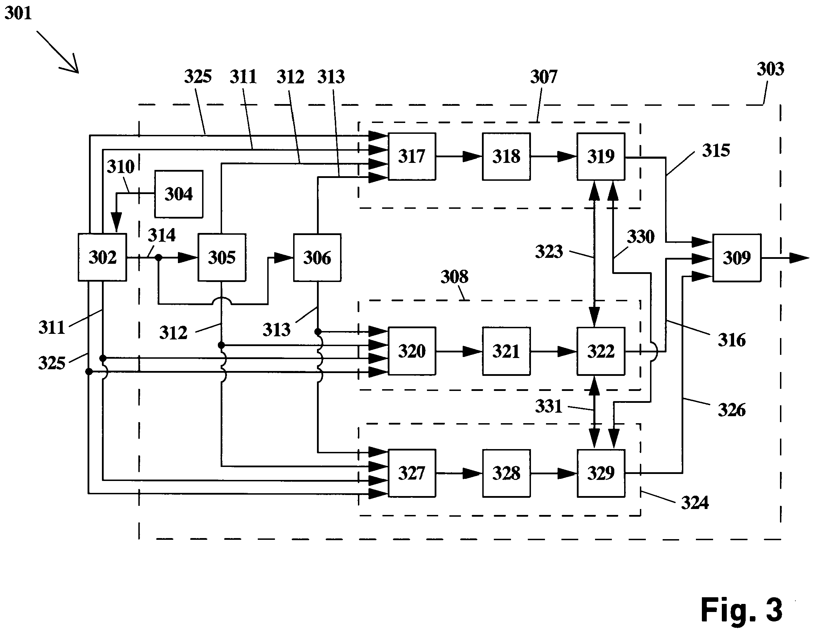

Der ganze vorstehend beschriebene Ablauf kann durch eine zentrale Steuereinrichtung wie beispielsweise einen Mikroprozessor oder eine andere Art von Steuerung gesteuert werden. Der Übersichtlichkeit halber wurde bei Fig. 1 ebenso wie bei Fig. 2 und Fig. 3 auf die Darstellung eines derartigen Elements verzichtet.

Fig. 2 zeigt das vereinfachte Blockschaltbild des Messsystems 201 gemäß dem zweiten Ausführungsbeispiel, in dem der Übersichtlichkeit halber nicht jede Einzelheit dargestellt ist.

Die Elemente 202 bis 223 entsprechen bis auf die im Folgenden erläuterten Modifikationen den im Zusammenhang mit dem ersten Ausführungsbeispiel beschriebenen Elementen 102 bis 123. Der Messverstärker 203 weist jedoch zwei Kanäle und dementsprechend eine zweite Verstärkereinrichtung 224 auf, um nicht nur das erste Messsignal 211, sondern auch ein zweites Messsignal 225 verarbeiten zu können. Entsprechend repräsentiert der mit dem Bezugszeichen 202 bezeichnete Block in dem vereinfachten Blockschaltbild der Fig. 2 auch zwei Messaufnehmer. Das zweite Messsignal 225 wird ebenso wie das erste Messsignal 211 durch Umformung einer gemessenen Größe in dem entsprechenden Messaufnehmer erzeugt und dem Messverstärker 203 bzw. zeitweise der zusätzlichen Verstärkereinrichtung 207 und zeitweise der zweiten Verstärkereinrichtung 224 zugeführt.

Die Spannungsquelle 204 kann die beiden durch den Block 202 dargestellten Messaufnehmer mit der gleichen Speisespannung versorgen. Alternativ kann der mit dem Bezugszeichen 204 bezeichnete Block in dem vereinfachten Blockschaltbild gemäß Fig. 2 auch zwei Spannungsquellen repräsentieren und der mit dem Bezugszeichen 210 versehene Pfeil entsprechend zwei verschiedene Speisespannungen für die beiden Messaufnehmer darstellen.

Je nachdem, welcher Kanal des Messverstärkers 203 gerade kalibriert werden soll, werden die erste Referenzsignalerzeugungseinrichtung 205 und die zweite Referenzsignalerzeugungseinrichtung 206 jeweils mit einer von dem entsprechenden Messaufnehmer zurückgeführten Spannung versorgt, um Leitungsverluste berücksichtigen zu können. Der mit dem Bezugszeichen 214 versehene Pfeil in dem vereinfachten Blockschaltbild der Fig. 2 repräsentiert somit zwei zurückgeführte Spannungen.

Um die zweite Verstärkereinrichtung 224 ebenso wie die Verstärkereinrichtungen 207 und 208 kalibrieren zu können, werden das von der ersten Referenzsignalerzeugungseinrichtung 205 erzeugte erste Referenzsignal 212 und das von der zweiten Referenzsignalerzeugungseinrichtung 206 erzeugte zweite Referenzsignal 213 zeitweise auch ihr zugeführt. Wie vorstehend bereits erläutert können auch mehr als zwei Referenzsignalerzeugungseinrichtungen vorgesehen sein oder durch eine einzelne Referenzsignalerzeugungseinrichtung mehrere Referenzsignale erzeugt werden. Es müssen nur für jede Kalibrierung zumindest zwei verschiedene Referenzsignale bzw. Referenzwerte wie beispielsweise Null- und Endwert verfügbar sein, damit sowohl der Nullpunktfehler als auch der Verstärkungsfehler ermittelt werden kann.

Die zweite Verstärkereinrichtung 224 gibt durch sie aus dem zweiten Messsignal 225 erzeugte Messwerte 226 aus. Sie ist in der gleicher Art und Weise wie die zusätzliche Verstärkereinrichtung 207 und die erste Verstärkereinrichtung 208 aufgebaut und umfasst eine zweite Verstärkerschaltung 227, einen zweiten Analog-Digital-Umsetzer 228 und eine zweite digitale Signalverarbeitungseinheit 229. Die zweite Verstärkerschaltung 227 weist einen Verstärker auf und kann weitere Elemente wie beispielsweise einen Demodulator und analoge Filter wie z. B. einen Tiefpass umfassen, was in Fig. 2 nicht im Einzelnen dargestellt ist. Die zweite digitale Signalverarbeitungseinheit 229 kann für verschiedene Berechnungen verwendet werden und weist ein digitales Filter oder mehrere digitale Filter auf, wobei in Fig. 2 kein derartiges Filter dargestellt ist.

Die Auswahleinrichtung 209 ist so aufgebaut, dass sie sowohl dem ersten Messsignal 211 entsprechende Messwerte als auch dem zweiten Messsignal 225 entsprechende Messwerte ausgibt. Entsprechend werden die Messwerte 216 und 226 oder aber in dem Fall, wo gerade kalibriert wird und die zusätzliche Verstärkereinrichtung 207 eine der beiden Verstärkereinrichtungen 208 und 224 ersetzt, die Messwerte 215 und die Messwerte der nicht ersetzten Verstärkereinrichtung, d. h. entweder die Messwerte 216 oder die Messwerte 226, ausgegeben.

Der Ablauf der Hintergrundkalibrierung und -justierung bzw. unterbrechungsfreien Kalibrierung und Justierung stellt sich bei dem Messverstärker 203 gemäß dem zweiten Ausführungsbeispiel mit zwei Kanälen und drei internen Verstärkereinrichtungen 207, 208 und 224 dar wie folgt.

Zunächst befindet sich die erste Verstärkereinrichtung 208 im Messzweig bzw. Messpfad. Ihr wird das erste Messsignal 211 zugeführt und sie verstärkt, digitalisiert und verarbeitet selbiges. Die dadurch aus dem ersten Messsignal 211 erzeugten Messwerte 216 werden über die Auswahleinrichtung 209 ausgegeben.

Die zusätzliche Verstärkereinrichtung 207 wird nun kalibriert und erforderlichenfalls justiert. Dafür werden das erste Referenzsignal 212 und das zweite Referenzsignal 213 benutzt, die in diesem Fall z. B. einen Nullwert und einen Endwert des ersten Messsignals 211 darstellen können. Wenn die Fehler der zusätzlichen Verstärkereinrichtung 207 herauskalibriert bzw. -justiert wurden, wird ihr das erste Messsignal 211 zugeführt und sie verstärkt, digitalisiert und verarbeitet selbiges. Nach dem Einschwingen oder "Einkopieren" ihrer Filter werden die durch sie aus dem ersten Messsignal 211 erzeugten Messwerte 215 über die Auswahleinrichtung 209 ausgegeben.

Die erste Verstärkereinrichtung 208 ist jetzt nicht mehr an der Messung beteiligt und kann aus dem Messpfad entfernt werden. Sobald dies geschehen ist, wird die erste Verstärkereinrichtung 208 kalibriert und erforderlichenfalls justiert, wobei wiederum die z. B. einen Nullwert und einen Endwert des ersten Messsignals 211 darstellenden Referenzsignale 212 und 213 verwendet werden. In diesem Zeitraum übernimmt die zusätzliche Verstärkereinrichtung 207 mit gleich bleibender Genauigkeit die Messaufgabe der ersten Verstärkereinrichtung 208. Nachdem die Fehler der ersten Verstärkereinrichtung 208 herauskalibriert bzw. -justiert wurden, wird diese in den Messpfad zurückgeschaltet. Nach dem Einschwingen oder "Einkopieren" ihrer Filter werden wieder die durch sie aus dem ersten Messsignal 211 erzeugten Messwerte 216 über die Auswahleinrichtung 209 ausgegeben.

Ab diesem Zeitpunkt ist die zusätzliche Verstärkereinrichtung 207 nicht mehr an der Messung beteiligt und wird aus dem Messpfad entfernt. Sie kann nun zum Ersetzen einer weiteren Verstärkereinrichtung verwendet werden, in diesem Fall der zweiten Verstärkereinrichtung 224.

Die zusätzliche Verstärkereinrichtung 207 wird jetzt erneut kalibriert und erforderlichenfalls justiert. Dafür werden das erste Referenzsignal 212 und das zweite Referenzsignal 213 oder in dem vereinfachten Blockschaltbild gemäß Fig. 2 nicht dargestellte weitere Referenzsignale verwendet, die nun unter Nutzung der von dem zweiten Messaufnehmer, der das zweite Messsignal 225 liefert, zurückgeführten Spannung erzeugt werden und z. B. einen Nullwert und einen Endwert des zweiten Messsignals 225 darstellen können. Wenn die Fehler der zusätzlichen Verstärkereinrichtung 207 herauskalibriert bzw. -justiert wurden, wird ihr das zweite Messsignal 225 zugeführt und sie verstärkt, digitalisiert und verarbeitet selbiges. Nach dem Einschwingen oder "Einkopieren" ihrer Filter werden die durch sie aus dem zweiten Messsignal 225 erzeugten Messwerte 215 über die Auswahleinrichtung 209 ausgegeben.

Die zweite Verstärkereinrichtung 224 ist jetzt nicht mehr an der Messung beteiligt und kann aus dem Messpfad entfernt werden. Sobald dies geschehen ist, wird die zweite Verstärkereinrichtung 224 kalibriert und erforderlichenfalls justiert, wobei wiederum die z. B. einen Nullwert und einen Endwert des zweiten Messsignals 225 darstellenden Referenzsignale 212 und 213 oder weitere Referenzsignale verwendet werden. In diesem Zeitraum übernimmt die zusätzliche Verstärkereinrichtung 207 mit gleich bleibender Genauigkeit die Messaufgabe der zweiten Verstärkereinrichtung 224. Nachdem die Fehler der zweiten Verstärkereinrichtung 224 herauskalibriert bzw. -justiert wurden, wird diese in den Messpfad zurückgeschaltet. Nach dem Einschwingen oder "Einkopieren" ihrer Filter werden wieder die durch sie aus dem zweiten Messsignal 225 erzeugten Messwerte 226 über die Auswahleinrichtung 209 ausgegeben.

Ab diesem Zeitpunkt ist die zusätzliche Verstärkereinrichtung 207 nicht mehr an der Messung beteiligt und wird aus dem Messpfad entfernt. Somit ist der ursprüngliche Zustand wieder erreicht.

Der Ablauf ist vorstehend nicht so detailliert beschrieben wie bei dem ersten Ausführungsbeispiel. Für weitere Einzelheiten wird auf die Beschreibung des ersten Ausführungsbeispiels Bezug genommen, wobei die dort zu findenden Erläuterungen bezüglich der ersten Verstärkereinrichtung 108 nicht nur für die erste Verstärkereinrichtung 208, sondern auch für die zweite Verstärkereinrichtung 224 in entsprechender Weise gelten.

Die Erläuterungen im Zusammenhang mit dem ersten Ausführungsbeispiel bezüglich des Filterumladens zur Elimination von Filtereinschwingzeiten gelten auch für das zweite Ausführungsbeispiel und insbesondere für die zweite Verstärkereinrichtung 224. Dass auch die Filterkoeffizienten und Zustandsspeicher bzw. Zustandsspeicherinhalte der zweiten Verstärkereinrichtung 224 bzw. der digitalen Filter der zweiten digitalen Signalverarbeitungseinheit 229 auf die zusätzliche Verstärkereinrichtung 207 bzw. die entsprechenden digitalen Filter der zusätzlichen digitalen Signalverarbeitungseinheit 219 kopiert werden können und umgekehrt ist in Fig. 2 durch einen Doppelpfeil 230 veranschaulicht.

Die Erläuterungen bezüglich der Umschaltzeitpunkte, der zum Umschalten verwendeten Schalter, der zyklischen Wiederholung des Ablaufs und einiger möglicher Varianten im Zusammenhang mit dem ersten Ausführungsbeispiel gelten ebenfalls für das zweite Ausführungsbeispiel.

Fig. 3 zeigt das vereinfachte Blockschaltbild des Messsystems 301 gemäß dem dritten Ausführungsbeispiel, in dem der Übersichtlichkeit halber nicht jede Einzelheit dargestellt ist.

Das dritte Ausführungsbeispiel baut auf dem zweiten Ausführungsbeispiel auf. Es handelt sich hier um eine Variante, bei der allgemein nicht nur die zusätzliche Verstärkereinrichtung parallel geschaltet werden kann, sondern jede Verstärkereinrichtung jeder anderen Verstärkereinrichtung parallel geschaltet werden kann. Dies hat den Vorteil, dass nach einer Kalibrierung nicht mehr zurückgeschaltet werden muss. Durch diese Modifikation ist es möglich, dass die Verstärkereinrichtungen rotieren können, d. h. nach der Kalibrierung bzw. Justierung einer Verstärkereinrichtung der dafür auf eine weitere Verstärkereinrichtung "verschobene" Kanal dort verbleibt und die gerade kalibrierte Verstärkereinrichtung als Ersatz für eine nächste zu kalibrierende Verstärkereinrichtung dient. Auf diese Weise kann durch eine Halbierung der Anzahl der Kalibriervorgänge das Verfahren beschleunigt werden.

Die Elemente 302 bis 330 entsprechen bis auf die im Folgenden erläuterten Modifikationen den im Zusammenhang mit dem zweiten Ausführungsbeispiel beschriebenen Elementen 202 bis 230.

Die vorstehend erläuterte Variante bedeutet bei dem dritten Ausführungsbeispiel mit drei internen Verstärkereinrichtungen konkret, dass nicht nur die zusätzliche Verstärkereinrichtung 307 parallel zu der ersten Verstärkereinrichtung 308 oder der zweiten Verstärkereinrichtung 324 geschaltet werden kann, sondern auch die erste Verstärkereinrichtung 308 und die zweite Verstärkereinrichtung 324 parallel zueinander geschaltet werden können. Dies bedingt Modifikationen bei dem zumindest einen Schalter, welcher der ersten Verstärkereinrichtung 308 zugeordnet ist, und dem zumindest einen Schalter, welcher der zweiten Verstärkereinrichtung 324 zugeordnet ist. Es muss mittels dieser Schalter zusätzlich möglich sein, auch der ersten Verstärkereinrichtung 308 das zweite Messsignal 325 zuzuführen und der zweiten Verstärkereinrichtung 324 das erste Messsignal 311 zuzuführen. Dies ist in dem vereinfachten Blockschaltbild gemäß Fig. 3 durch zusätzliche Verbindungslinien dargestellt.

Für die Realisierung des Filterumladens muss es zusätzlich möglich sein, auch die Filterkoeffizienten und Zustandsspeicher bzw. Zustandsspeicherinhalte der zweiten Verstärkereinrichtung 324 bzw. der digitalen Filter der zweiten digitalen Signalverarbeitungseinheit 329 auf die erste Verstärkereinrichtung 308 bzw. die entsprechenden digitalen Filter der ersten digitalen Signalverarbeitungseinheit 322 zu kopieren und umgekehrt. Dies ist in Fig. 3 durch einen Doppelpfeil 331 veranschaulicht.

Der Ablauf der Hintergrundkalibrierung und -justierung bzw. unterbrechungsfreien Kalibrierung und Justierung stellt sich bei dem Messverstärker 303 gemäß dem dritten Ausführungsbeispiel mit zwei Kanälen und drei internen Verstärkereinrichtungen 307, 308 und 324 beispielsweise wie folgt dar.

Zunächst befindet sich die erste Verstärkereinrichtung 308 im Messzweig bzw. Messpfad. Ihr wird das erste Messsignal 311 zugeführt und sie verstärkt, digitalisiert und verarbeitet selbiges. Die dadurch aus dem ersten Messsignal 311 erzeugten Messwerte 316 werden über die Auswahleinrichtung 309 ausgegeben.

Die zusätzliche Verstärkereinrichtung 307 wird nun kalibriert und erforderlichenfalls justiert. Dafür werden das erste Referenzsignal 312 und das zweite Referenzsignal 313 benutzt, die in diesem Fall z. B. einen Nullwert und einen Endwert des ersten Messsignals 311 darstellen können.

Wenn die Fehler der zusätzlichen Verstärkereinrichtung 307 herauskalibriert bzw. -justiert wurden, wird ihr das erste Messsignal 311 zugeführt und sie verstärkt, digitalisiert und verarbeitet selbiges. Nach dem Einschwingen oder "Einkopieren" ihrer Filter werden die durch sie aus dem ersten Messsignal 311 erzeugten Messwerte 315 über die Auswahleinrichtung 309 ausgegeben.

Die erste Verstärkereinrichtung 308 ist jetzt nicht mehr an der Messung beteiligt und kann aus dem Messpfad entfernt werden. Sobald dies geschehen ist, wird die erste Verstärkereinrichtung 308 kalibriert und erforderlichenfalls justiert. In diesem Zeitraum übernimmt die zusätzliche Verstärkereinrichtung 307 mit gleich bleibender Genauigkeit die Messaufgabe der ersten Verstärkereinrichtung 308.

Der ersten Verstärkereinrichtung 308 soll als Nächstes nicht wieder das erste Messsignal 311, sondern das zweite Messsignal 325 zugeführt werden. Daher werden für ihre Kalibrierung das erste Referenzsignal 312 und das zweite Referenzsignal 313 oder in dem vereinfachten Blockschaltbild gemäß Fig. 3 nicht dargestellte weitere Referenzsignale verwendet, die jetzt unter Nutzung der von dem zweiten Messaufnehmer, der das zweite Messsignal 325 liefert, zurückgeführten Spannung erzeugt werden und z. B. einen Nullwert und einen Endwert des zweiten Messsignals 325 darstellen können.

Wenn die Fehler der ersten Verstärkereinrichtung 308 herauskalibriert bzw. -justiert wurden, wird ihr das zweite Messsignal 325 zugeführt und sie verstärkt, digitalisiert und verarbeitet selbiges. Nach dem Einschwingen oder "Einkopieren" ihrer Filter werden die durch sie aus dem zweiten Messsignal 325 erzeugten Messwerte 316 über die Auswahleinrichtung 309 ausgegeben.

Ab diesem Zeitpunkt ist die zweite Verstärkereinrichtung 324 nicht mehr an der Messung beteiligt und wird aus dem Messpfad entfernt. Sie kann nun zum Ersetzen einer anderen Verstärkereinrichtung verwendet werden, in diesem Fall der zusätzlichen Verstärkereinrichtung 307.

Die zweite Verstärkereinrichtung 324 wird kalibriert und erforderlichenfalls justiert. Dafür werden das erste Referenzsignal 312 und das zweite Referenzsignal 313 oder in dem vereinfachten Blockschaltbild gemäß Fig. 3 nicht dargestellte weitere Referenzsignale verwendet, die nun unter Nutzung der von dem ersten Messaufnehmer, der das erste Messsignal 311 liefert, zurückgeführten Spannung erzeugt werden und z. B. einen Nullwert und einen Endwert des ersten Messsignals 311 darstellen können.

Wenn die Fehler der zweiten Verstärkereinrichtung 324 herauskalibriert bzw. -justiert wurden, wird ihr das erste Messsignal 311 zugeführt und sie verstärkt, digitalisiert und verarbeitet selbiges. Nach dem Einschwingen oder "Einkopieren" ihrer Filter werden die durch sie aus dem ersten Messsignal 311 erzeugten Messwerte 326 über die Auswahleinrichtung 309 ausgegeben.

Die zusätzliche Verstärkereinrichtung 307 ist jetzt nicht mehr an der Messung beteiligt und kann aus dem Messpfad entfernt werden. Zu dieser Zeit werden dem ersten Messsignal 311 entsprechende Messwerte 326 durch die zweite Verstärkereinrichtung 324 erzeugt und dem zweiten Messsignal 325 entsprechende Messwerte 316 durch die erste Verstärkereinrichtung 308 erzeugt und jeweils über die Auswahleinrichtung 309 ausgegeben. Somit hat die zweite Verstärkereinrichtung 324 die ursprüngliche Messaufgabe der ersten Verstärkereinrichtung 308 übernommen und umgekehrt.

Als Nächstes wird wieder die zusätzliche Verstärkereinrichtung 307 kalibriert und erforderlichenfalls justiert. Diese soll nun nicht wieder das erste Messsignal 311, sondern das zweite Messsignal 325 von der ersten Verstärkereinrichtung 308 übernehmen. Daher werden jetzt für ihre Kalibrierung das erste Referenzsignal 312 und das zweite Referenzsignal 313 oder in dem vereinfachten Blockschaltbild gemäß Fig. 3 nicht dargestellte weitere Referenzsignale verwendet, die unter Nutzung der von dem zweiten Messaufnehmer, der das zweite Messsignal 325 liefert, zurückgeführten Spannung erzeugt werden und z. B. einen Nullwert und einen Endwert des zweiten Messsignals 325 darstellen können.

Wenn die Fehler der zusätzlichen Verstärkereinrichtung 307 herauskalibriert bzw. -justiert wurden, wird ihr das zweite Messsignal 325 zugeführt und sie verstärkt, digitalisiert und verarbeitet selbiges. Nach dem Einschwingen oder "Einkopieren" ihrer Filter werden die durch sie aus dem zweiten Messsignal 325 erzeugten Messwerte 315 über die Auswahleinrichtung 309 ausgegeben.

Die erste Verstärkereinrichtung 308 ist jetzt nicht mehr an der Messung beteiligt und kann aus dem Messpfad entfernt werden. Sobald dies geschehen ist, wird die erste Verstärkereinrichtung 308 kalibriert und erforderlichenfalls justiert. Sie soll als Nächstes wieder das erste Messsignal 311 übernehmen, und zwar von der zweiten Verstärkereinrichtung 324. Daher werden für ihre Kalibrierung wieder das erste Referenzsignal 312 und das zweite Referenzsignal 313 verwendet, die unter Nutzung der von dem ersten Messaufnehmer, der das erste Messsignal 311 liefert, zurückgeführten Spannung erzeugt werden und z. B. einen Nullwert und einen Endwert des ersten Messsignals 311 darstellen können.

Wenn die Fehler der ersten Verstärkereinrichtung 308 herauskalibriert bzw. -justiert wurden, wird ihr das erste Messsignal 311 zugeführt und sie verstärkt, digitalisiert und verarbeitet selbiges. Nach dem Einschwingen oder "Einkopieren" ihrer Filter werden die durch sie aus dem ersten Messsignal 311 erzeugten Messwerte 316 über die Auswahleinrichtung 309 ausgegeben.

Ab diesem Zeitpunkt ist die zweite Verstärkereinrichtung 324 nicht mehr an der Messung beteiligt und wird aus dem Messpfad entfernt. Sie kann nun wieder zum Ersetzen der zusätzlichen Verstärkereinrichtung 307 verwendet werden.

Die zweite Verstärkereinrichtung 324 wird kalibriert und erforderlichenfalls justiert. Sie soll als Nächstes wieder das zweite Messsignal 325 übernehmen, und zwar von der zusätzlichen Verstärkereinrichtung 307. Daher werden für ihre Kalibrierung das erste Referenzsignal 312 und das zweite Referenzsignal 313 oder in dem vereinfachten Blockschaltbild gemäß Fig. 3 nicht dargestellte weitere Referenzsignale verwendet, die nun unter Nutzung der von dem zweiten Messaufnehmer, der das zweite Messsignal 325 liefert, zurückgeführten Spannung erzeugt werden und z. B. einen Nullwert und einen Endwert des zweiten Messsignals 325 darstellen können.

Wenn die Fehler der zweiten Verstärkereinrichtung 324 herauskalibriert bzw. -justiert wurden, wird ihr das zweite Messsignal 325 zugeführt und sie verstärkt, digitalisiert und verarbeitet selbiges. Nach dem Einschwingen oder "Einkopieren" ihrer Filter werden die durch sie aus dem zweiten Messsignal 325 erzeugten Messwerte 326 über die Auswahleinrichtung 309 ausgegeben.

Die zusätzliche Verstärkereinrichtung 307 ist nun nicht mehr an der Messung beteiligt und wird aus dem Messpfad entfernt. Dem ersten Messsignal 311 entsprechende Messwerte 316 werden durch die erste Verstärkereinrichtung 308 erzeugt und dem zweiten Messsignal 325 entsprechende Messwerte 326 durch die zweite Verstärkereinrichtung 324 erzeugt und jeweils über die Auswahleinrichtung 309 ausgegeben. Somit ist der ursprüngliche Zustand wieder erreicht.

Vorstehend ist ein lediglich beispielhafter Ablauf beschrieben. Da gemäß dem dritten Ausführungsbeispiel jede Verstärkereinrichtung jeder anderen Verstärkereinrichtung parallel geschaltet werden kann und diese dementsprechend ersetzen kann, sind insbesondere bei einem Messverstärker mit mehr als zwei Kanälen und daher mehr als drei Verstärkereinrichtungen zahlreiche Varianten möglich. So könnte - um nur ein Beispiel zu nennen - die zusätzliche Verstärkereinrichtung zu Beginn statt der ersten Verstärkereinrichtung die letzte Verstärkereinrichtung ersetzen und die ganze Rotation der Verstärkereinrichtungen in umgekehrter Reihenfolge ablaufen. Die freie Umschaltbarkeit jeder einzelnen Verstärkereinrichtung ermöglicht ein völlig flexibles Hin- und Herschalten zwischen den Verstärkereinrichtungen und Übernehmen von Messsignalen bzw. Kanälen. Somit sind viele andere Varianten denkbar.

Die Erläuterungen bezüglich des Filterumladens, der Umschaltzeitpunkte, der zum Umschalten verwendeten Schalter, der zyklischen Wiederholung des Ablaufs und einiger möglicher Varianten im Zusammenhang mit dem ersten Ausführungsbeispiel gelten auch für das dritte Ausführungsbeispiel.

Gemäß einem vierten Ausführungsbeispiel, das für einen Messverstärker mit nur einem Kanal ebenso wie das erste Ausführungsbeispiel in Fig. 1 veranschaulicht ist, weist der Messverstärker für jeden seiner Kanäle eine eigene zusätzliche Verstärkereinrichtung auf. Es wird somit nicht wie bei den vorhergehenden Ausführungsbeispielen nur eine einzige zusätzliche Verstärkereinrichtung benötigt. Bei einem Messverstärker mit N Kanälen sind folglich 2 x N Verstärkereinrichtungen statt N+1 Verstärkereinrichtungen erforderlich.

Dadurch ist zwar der Hardwareaufwand höher als bei den anderen Ausführungsbeispielen. Dafür kommt das vierte Ausführungsbeispiel allerdings auch für Messverstärker mit galvanisch getrennten Kanälen infrage und kann auch bei diesen mit hoher Genauigkeit arbeiten. Zudem ermöglicht es das Vorhandensein einer zusätzlichen Verstärkereinrichtung für jeden einzelnen Kanal, die Kalibrierung und Justierung für mehrere Kanäle gleichzeitig durchzuführen und so das Kalibrier- und Justierverfahren mit einer höheren Frequenz bzw. einer kürzeren Zykluszeit auszuführen. Dies kann die Genauigkeit noch weiter erhöhen.

Die Erläuterungen bezüglich des Ablaufs der unterbrechungsfreien Kalibrierung und Justierung für einen Kanal, des Filterumladens, der Umschaltzeitpunkte, der zum Umschalten verwendeten Schalter, der zyklischen Wiederholung des Ablaufs und einiger möglicher Varianten im Zusammenhang mit dem ersten Ausführungsbeispiel gelten auch für das vierte Ausführungsbeispiel.

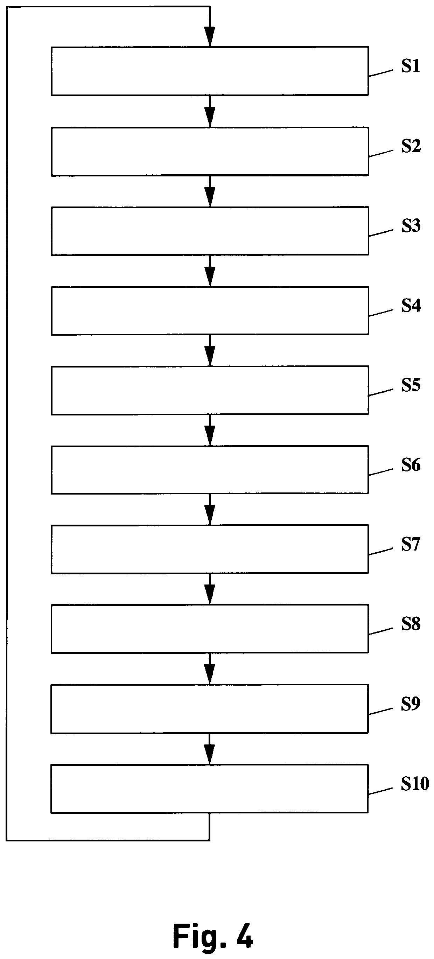

Fig. 4 zeigt das Flussdiagramm mit den grundlegenden Schritten eines Verfahrens zum unterbrechungsfreien Kalibrieren und Justieren eines Messverstärkers, die den vorstehend beschriebenen Ausführungsbeispielen gemein sind. Dies sind bei einem Messverstärker für N Messsignale, der zumindest N+1 Verstärkereinrichtungen aufweist und zum Ausgeben von N Messwerten, die den N Messsignalen entsprechen, eingerichtet ist, die folgenden Schritte, wobei N ≥ 1 gilt und ein Index i von 1 bis N läuft.

In einem Schritt S1 wird einer i-ten Verstärkereinrichtung der zumindest N+1 Verstärkereinrichtungen ein i-tes Messsignal der N Messsignale zugeführt. In einem Schritt S2 werden durch die i-te Verstärkereinrichtung aus dem i-ten Messsignal erzeugte Messwerte ausgegeben. In einem Schritt S3 werden einer weiteren Verstärkereinrichtung der zumindest N+1 Verstärkereinrichtungen zumindest zwei i-te Referenzsignale zugeführt. In einem Schritt S4 wird die weitere Verstärkereinrichtung mithilfe der zumindest zwei i-ten Referenzsignale kalibriert, wobei ein Nullpunktfehler und ein Verstärkungsfehler der weiteren Verstärkereinrichtung ermittelt werden. In einem Schritt S5 wird die weitere Verstärkereinrichtung justiert, falls zumindest einer der für sie ermittelten Fehler oberhalb eines vorgegebenen Schwellenwerts für diesen Fehler liegt. In einem Schritt S6 wird der weiteren Verstärkereinrichtung das i-te Messsignal zugeführt. In einem Schritt S7 werden durch die weitere Verstärkereinrichtung aus dem i-ten Messsignal erzeugte Messwerte ausgegeben. In einem Schritt S8 werden der i-ten Verstärkereinrichtung zumindest zwei Referenzsignale zugeführt. In einem Schritt S9 wird die i-te Verstärkereinrichtung mithilfe der zumindest zwei Referenzsignale kalibriert, wobei ein Nullpunktfehler und ein Verstärkungsfehler der i-ten Verstärkereinrichtung ermittelt werden. In einem Schritt S10 wird die i-te Verstärkereinrichtung justiert, falls zumindest einer der für sie ermittelten Fehler oberhalb des vorgegebenen Schwellenwerts für diesen Fehler liegt.

Es werden die Schritte S1 bis S10 für jeden Kanal des Messverstärkers ausgeführt und der ganze Vorgang zyklisch wiederholt, was durch einen Pfeil von dem den Schritt S10 repräsentierenden Block zurück zu dem den Schritt S1 repräsentierenden Block in dem Flussdiagramm gemäß Fig. 4 angedeutet ist.

Nach dem Schritt S10 kann je nach Ausführungsbeispiel noch zumindest ein weiterer Schritt ausgeführt werden. So kann z. B. bei dem ersten, zweiten und vierten Ausführungsbeispiel nach dem Schritt S10 der i-ten Verstärkereinrichtung wieder das i-te Messsignal zugeführt werden wie schon in dem Schritt S1, d. h. das gleiche Messsignal wie vor ihrer Kalibrierung. Daraufhin können wieder die durch die i-te Verstärkereinrichtung aus dem i-ten Messsignal erzeugten Messwerte ausgegeben werden wie schon in dem Schritt S2. Bei dem dritten Ausführungsbeispiel kann hingegen nach dem Schritt S10 der i-ten Verstärkereinrichtung ein anderes Messsignal zugeführt werden, d. h. ein anderes Messsignal als vor ihrer Kalibrierung. Mit anderen Worten kann nach dem Schritt S10 der i-ten Verstärkereinrichtung das gleiche Messsignal wie vor ihrer Kalibrierung oder ein anderes Messsignal als vor ihrer Kalibrierung zugeführt werden.

Weiterhin können zwischen einzelnen Schritten der Schritte S1 bis S10 noch zusätzliche Schritte wie beispielsweise Schritte des Filterumladens oder des Korrigierens einer Differenz von Eigenfehlern der Verstärkereinrichtungen ausgeführt werden.

Der für die Beschreibung der Schritte S1 bis S10 und in den Patentansprüchen verwendete Index i muss nicht zwangsläufig der Bezeichnung der Verstärkereinrichtungen, Messsignale und Referenzsignale in der vorstehenden Beschreibung der Ausführungsbeispiele entsprechen. So muss z. B. bei i = 1 die i-te Verstärkereinrichtung nicht unbedingt die erste Verstärkereinrichtung sein und das i-te Messsignal nicht unbedingt das erste Messsignal sein. Ebenso müssen die i-ten Referenzsignale nicht Referenzwerten des ersten Messsignals entsprechende Referenzsignale sein. Dies gilt insbesondere bei dem dritten Ausführungsbeispiel, das ein sehr flexibles Hin- und Herschalten zwischen den Verstärkereinrichtungen ermöglicht.

Zudem ist zwar die Reihenfolge der Schritte S1 bis S10 und der weiteren in den Patentansprüchen definierten Schritte grundsätzlich so wie angegeben. Es können jedoch teilweise mehrere aufeinanderfolgende Schritte parallel ausgeführt werden, z. B. die Schritte des Zuführens eines Messsignals zu einer Verstärkereinrichtung, des Ausgebens von durch sie daraus erzeugten Messwerten, des Zuführens von Referenzsignalen zu einer anderen Verstärkereinrichtung und des Kalibrierens der anderen Verstärkereinrichtung mit den Referenzsignalen.

Während vorstehend bei jedem der vier Ausführungsbeispiele mehrere Verstärkereinrichtungen mit jeweils mehreren Komponenten beschrieben sind, so sind auch andere Konfigurationen möglich. Es können z. B. einige oder alle Verstärkereinrichtungen und/oder weitere Bestandteile des Messverstärkers in Form einer integrierten Schaltung realisiert sein oder auch nur jeweils bestimmte Komponenten jeder Verstärkereinrichtung wie z. B. Verstärkerschaltung und Analog-Digital-Umsetzer miteinander integriert sein. Ebenso können beispielsweise analoge statt digitaler Messwerte erzeugt werden, wenn jeweils nach einer digitalen Signalverarbeitungseinheit noch ein Digital-Analog-Umsetzer vorgesehen ist. Es wäre sogar denkbar, das Grundprinzip des erläuterten Verfahrens zum unterbrechungsfreien Kalibrieren und Justieren eines Messverstärkers bei einem rein analog arbeitenden Messverstärker anzuwenden.

Zusammenfassend bezieht sich die vorliegende Erfindung auf einen Messverstärker mit Hintergrundkalibrierung und -justierung sowie auf ein Verfahren zum Durchführen der Hintergrundkalibrierung und -justierung für einen derartigen Messverstärker. Der Messverstärker verstärkt, digitalisiert und verarbeitet zumindest ein Messsignal von zumindest einem Messaufnehmer mithilfe zumindest einer Verstärkereinrichtung. Diese kann zeitweise durch eine zusätzliche Verstärkereinrichtung ersetzt werden, was ihre unterbrechungsfreie Kalibrierung und erforderlichenfalls Justierung ermöglicht. Bei der Kalibrierung werden zuverlässig sowohl ein Nullpunktfehler als auch ein Verstärkungsfehler der Verstärkereinrichtung ermittelt. Zudem wird die Verstärkereinrichtung direkt und nicht indirekt kalibriert. Somit wird ohne Messunterbrechung eine hohe Genauigkeit erreicht. Darüber hinaus wird in der Regel auch bei einem Messverstärker mit mehreren Kanälen nur eine zusätzliche Verstärkereinrichtung benötigt.

## Patentansprüche

1. Verfahren zum unterbrechungsfreien Kalibrieren und Justieren eines Messverstärkers (103; 203; 303) für N Messsignale (111; 211, 225; 311, 325), der zumindest N+1 Verstärkereinrichtungen (107, 108; 207, 208, 224; 307, 308, 324), die jeweils eine Verstärkerschaltung (117, 120; 217, 220, 227; 317, 320, 327), einen Analog-Digital-Umsetzer (118, 121; 218, 221, 228; 318, 321, 328) und eine digitale Signalverarbeitungseinheit (119, 122; 219, 222, 229; 319, 322, 329) mit zumindest einem digitalen Filter aufweisen, aufweist und zum Ausgeben von N Messwerten, die den N Messsignalen entsprechen, eingerichtet ist, wobei N ≥ 1 gilt und für i = 1 bis N die folgenden Schritte ausgeführt werden:
Zuführen (S1) eines i-ten Messsignals der N Messsignale zu einer i-ten Verstärkereinrichtung der zumindest N+1 Verstärkereinrichtungen;
Ausgeben (S2) von durch die i-te Verstärkereinrichtung aus dem i-ten Messsignal erzeugten Messwerten;
Zuführen (S3) von zumindest zwei i-ten Referenzsignalen (112, 113; 212, 213; 312, 313) zu einer weiteren Verstärkereinrichtung der zumindest N+1 Verstärkereinrichtungen;
Kalibrieren (S4) der weiteren Verstärkereinrichtung mithilfe der zumindest zwei i-ten Referenzsignale, wobei ein Nullpunktfehler und ein Verstärkungsfehler der weiteren Verstärkereinrichtung ermittelt werden;
Justieren (S5) der weiteren Verstärkereinrichtung, falls zumindest einer der für sie ermittelten Fehler oberhalb eines vorgegebenen Schwellenwerts für diesen Fehler liegt;
Zuführen (S6) des i-ten Messsignals zu der weiteren Verstärkereinrichtung;
Ausgeben (S7) von durch die weitere Verstärkereinrichtung aus dem i-ten Messsignal erzeugten Messwerten;
Zuführen (S8) von zumindest zwei Referenzsignalen zu der i-ten Verstärkereinrichtung;
Kalibrieren (S9) der i-ten Verstärkereinrichtung mithilfe der ihr zugeführten zumindest zwei Referenzsignale, wobei ein Nullpunktfehler und ein Verstärkungsfehler der i-ten Verstärkereinrichtung ermittelt werden; und
Justieren (S10) der i-ten Verstärkereinrichtung, falls zumindest einer der für sie ermittelten Fehler oberhalb des vorgegebenen Schwellenwerts für diesen Fehler liegt,
**dadurch gekennzeichnet, dass**
nach dem Schritt des Zuführens (S6) des i-ten Messsignals zu der weiteren Verstärkereinrichtung und vor dem Schritt des Ausgebens (S7) von durch die weitere Verstärkereinrichtung aus dem i-ten Messsignal erzeugten Messwerten ein Schritt des Kopierens von Filterkoeffizienten und Zustandsspeichern des zumindest einen digitalen Filters der i-ten Verstärkereinrichtung auf das zumindest eine digitale Filter der weiteren Verstärkereinrichtung ausgeführt wird, und
nach einem Schritt des Zuführens eines bisher einer anderen Verstärkereinrichtung der zumindest N+1 Verstärkereinrichtungen zugeführten anderen Messsignals der N Messsignale zu der i-ten Verstärkereinrichtung und vor einem Schritt des Ausgebens von durch die i-te Verstärkereinrichtung aus dem anderen Messsignal erzeugten Messwerten ein Schritt des Kopierens von Filterkoeffizienten und Zustandsspeichern des zumindest einen digitalen Filters der anderen Verstärkereinrichtung auf das zumindest eine digitale Filter der i-ten Verstärkereinrichtung ausgeführt wird.

2. Verfahren nach Anspruch 1, wobei j ≥ 1 gilt und
die weitere Verstärkereinrichtung eine (N+j)-te Verstärkereinrichtung (107; 207) der zumindest N+1 Verstärkereinrichtungen ist,
zum Kalibrieren der i-ten Verstärkereinrichtung (108; 208, 224) die zumindest zwei i-ten Referenzsignale verwendet werden, und
nach dem Schritt des Justierens der i-ten Verstärkereinrichtung wieder das i-te Messsignal (111; 211, 225) der i-ten Verstärkereinrichtung zugeführt und die durch sie erzeugten Messwerte (116; 216, 226) ausgegeben werden.

3. Verfahren nach Anspruch 1, wobei j ≥ 1 gilt und
für i = 1
die weitere Verstärkereinrichtung eine (N+j)-te Verstärkereinrichtung (307) der zumindest N+1 Verstärkereinrichtungen ist, zum Kalibrieren der i-ten Verstärkereinrichtung (308) zumindest zwei (i+1)-te Referenzsignale verwendet werden, und nach dem Schritt des Justierens der i-ten Verstärkereinrichtung ein bisher einer (i+1)-ten Verstärkereinrichtung (324) der zumindest N+1 Verstärkereinrichtungen zugeführtes Messsignal der N Messsignale der i-ten Verstärkereinrichtung zugeführt und durch die i-te Verstärkereinrichtung aus diesem Messsignal erzeugte Messwerte (316) ausgegeben werden,
für 1 < i < N
die weitere Verstärkereinrichtung eine (i-1)-te Verstärkereinrichtung der zumindest N+1 Verstärkereinrichtungen ist, zum Kalibrieren der i-ten Verstärkereinrichtung zumindest zwei (i+1)-te Referenzsignale verwendet werden, und nach dem Schritt des Justierens der i-ten Verstärkereinrichtung ein bisher einer (i+1)-ten Verstärkereinrichtung der zumindest N+1 Verstärkereinrichtungen zugeführtes Messsignal der N Messsignale der i-ten Verstärkereinrichtung zugeführt und durch die i-te Verstärkereinrichtung aus diesem Messsignal erzeugte Messwerte ausgegeben werden, und
für i = N
die weitere Verstärkereinrichtung eine (i-1)-te Verstärkereinrichtung (308) der zumindest N+1 Verstärkereinrichtungen ist, zum Kalibrieren der i-ten Verstärkereinrichtung (324) zumindest zwei (N+j)-te Referenzsignale verwendet werden, und nach dem Schritt des Justierens der i-ten Verstärkereinrichtung ein bisher der (N+j)-ten Verstärkereinrichtung (307) der zumindest N+1 Verstärkereinrichtungen zugeführtes Messsignal der N Messsignale der i-ten Verstärkereinrichtung zugeführt und durch die i-te Verstärkereinrichtung aus diesem Messsignal erzeugte Messwerte (326) ausgegeben werden.

4. Verfahren nach Anspruch 1, wobei der Messverstärker zumindest 2 x N Verstärkereinrichtungen aufweist und wobei
die weitere Verstärkereinrichtung eine (i+N)-te Verstärkereinrichtung der zumindest 2 x N Verstärkereinrichtungen ist,
zum Kalibrieren der i-ten Verstärkereinrichtung die zumindest zwei i-ten Referenzsignale verwendet werden, und
nach dem Schritt des Justierens der i-ten Verstärkereinrichtung wieder das i-te Messsignal der i-ten Verstärkereinrichtung zugeführt und die durch sie erzeugten Messwerte ausgegeben werden.

5. Verfahren nach Anspruch 1, wobei die Verstärkereinrichtungen des Messverstärkers jeweils zumindest ein Filter aufweisen und wobei
nach dem Schritt des Zuführens (S6) des i-ten Messsignals zu der weiteren Verstärkereinrichtung und vor dem Schritt des Ausgebens (S7) von durch die weitere Verstärkereinrichtung aus dem i-ten Messsignal erzeugten Messwerten gewartet wird, bis das zumindest eine Filter der weiteren Verstärkereinrichtung eingeschwungen ist, und
nach einem Schritt des Zuführens eines bisher einer anderen Verstärkereinrichtung der zumindest N+1 Verstärkereinrichtungen zugeführten anderen Messsignals der N Messsignale zu der i-ten Verstärkereinrichtung und vor einem Schritt des Ausgebens von durch die i-te Verstärkereinrichtung aus dem anderen Messsignal erzeugten Messwerten gewartet wird, bis das zumindest eine Filter der i-ten Verstärkereinrichtung eingeschwungen ist.

6. Verfahren nach Anspruch 1, wobei
nach dem Schritt des Zuführens (S6) des i-ten Messsignals zu der weiteren Verstärkereinrichtung und vor dem Schritt des Ausgebens (S7) von durch die weitere Verstärkereinrichtung aus dem i-ten Messsignal erzeugten Messwerten ein Schritt des Korrigierens einer Differenz der Eigenfehler der i-ten Verstärkereinrichtung und der weiteren Verstärkereinrichtung ausgeführt wird, und
nach einem Schritt des Zuführens eines bisher einer anderen Verstärkereinrichtung der zumindest N+1 Verstärkereinrichtungen zugeführten anderen Messsignals der N Messsignale zu der i-ten Verstärkereinrichtung und vor einem Schritt des Ausgebens von durch die i-te Verstärkereinrichtung aus dem anderen Messsignal erzeugten Messwerten ein Schritt des Korrigierens einer Differenz der Eigenfehler der anderen Verstärkereinrichtung und der i-ten Verstärkereinrichtung ausgeführt wird.

7. Verfahren nach einem der vorhergehenden Ansprüche, wobei alle Schritte zyklisch wiederholt werden, um den Messverstärker in vorgegebenen Zeitabständen automatisch zu kalibrieren und erforderlichenfalls zu justieren.

8. Messverstärker (103; 203; 303) zum Ausführen eines Verfahrens nach einem der vorhergehenden Ansprüche, wobei der Messverstärker die folgenden Merkmale aufweist:
die zumindest N+1 Verstärkereinrichtungen (107, 108; 207, 208, 224; 307, 308, 324), die jeweils die Verstärkerschaltung (117, 120; 217, 220, 227; 317, 320, 327), den Analog-Digital-Umsetzer (118, 121; 218, 221, 228; 318, 321, 328) und die digitale Signalverarbeitungseinheit (119, 122; 219, 222, 229; 319, 322, 329) mit dem zumindest einen digitalen Filter aufweisen;
zumindest N+1 Schalter, die jeweils einer der N+1 Verstärkereinrichtungen zugeordnet sind;
zumindest eine Referenzsignalerzeugungseinrichtung (105, 106; 205, 206; 305, 306); und
zumindest eine Auswahleinrichtung (109; 209; 309), wobei
jede Verstärkereinrichtung der N+1 Verstärkereinrichtungen mithilfe von durch die zumindest eine Referenzsignalerzeugungseinrichtung erzeugten Referenzsignalen kalibrierbar und justierbar ist,
eine Verstärkereinrichtung der zumindest N+1 Verstärkereinrichtungen zu jeder der anderen Verstärkereinrichtungen parallel schaltbar ist, jede Verstärkereinrichtung der zumindest N+1 Verstärkereinrichtungen jeweils zu jeder der anderen Verstärkereinrichtungen parallel schaltbar ist oder jede Verstärkereinrichtung der zumindest N+1 Verstärkereinrichtungen zu genau einer anderen Verstärkereinrichtung parallel schaltbar ist, wobei die jeweilige Umschaltung über entsprechende Schalter der zumindest N+1 Schalter ausführbar ist, und
die zumindest eine Auswahleinrichtung zum Ausgeben von N Messwerten, die den N Messsignalen entsprechen, eingerichtet ist
**dadurch gekennzeichnet, dass**
der Messverstärker zum Kopieren von Filterkoeffizienten und Zustandsspeichern des zumindest einen digitalen Filters einer Ausgangsverstärkereinrichtung der zumindest N+1 Verstärkereinrichtungen, deren Messaufgabe durch eine Zielverstärkereinrichtung der zumindest N+1 Verstärkereinrichtungen übernommen wird, auf das zumindest eine digitale Filter der Zielverstärkereinrichtung nach einem Zuführen eines i-ten Messsignals der N Messsignale zu der Zielverstärkereinrichtung und vor einem Ausgeben von durch die Zielverstärkereinrichtung aus dem i-ten Messsignal erzeugten Messwerten eingerichtet ist.

9. Messsystem (101; 201; 301) mit einem Messverstärker (103; 203; 303) nach Anspruch 8 und zumindest einem Messaufnehmer (102; 202; 302), der zum Zuführen der N Messsignale zu dem Messverstärker eingerichtet ist.

## Claims

1. A method of calibrating and adjusting in an uninterrupted fashion a measurement amplifier (103; 203; 303) for N measurement signals (111; 211, 225; 311, 325), said measurement amplifier having at least N+1 amplifier units (107, 108; 207, 208, 224; 307, 308, 324) each having an amplifier circuit (117, 120; 217, 220, 227; 317, 320, 327), an analogue-to-digital converter (118, 121; 218, 221, 228; 318, 321, 328) and a digital signal processing unit (119, 122; 219, 222, 229; 319, 322, 329) comprising at least one digital filter, said measurement amplifier being configured to output N measurement values corresponding to the N measurement signals, where N is greater than or equal to one, said method comprising the following steps for i = 1 to N:
feeding (S1) an i-th measurement signal of the N measurement signals to an i-th amplifier unit of the at least N+1 amplifier units;
outputting (S2) measurement values produced by the i-th amplifier unit from the i-th measurement signal;
feeding (S3) at least two i-th reference signals (112, 113; 212, 213; 312, 313) to a further amplifier unit of the at least N+1 amplifier units;
calibrating (S4) the further amplifier unit with the aid of the at least two i-th reference signals, wherein a zero point error and a gain error of the further amplifier unit are determined;
adjusting (S5) the further amplifier unit if at least one of the errors determined for it is above a predetermined threshold value for said error;
feeding (S6) the i-th measurement signal to the further amplifier unit;
outputting (S7) measurement values produced by the further amplifier unit from the i-th measurement signal;
feeding (S8) at least two reference signals to the i-th amplifier unit;
calibrating (S9) the i-th amplifier unit with the aid of the at least two reference signals fed thereto, wherein a zero error and a gain error of the i-th amplifier unit are determined; and
adjusting (S10) the i-th amplifier unit if at least one of the errors determined for it is above the predetermined threshold value for said error,
**characterised in that.**
after the step of feeding (S6) the i-th measurement signal to the further amplifier unit and before the step of outputting (S7) measurement values produced by the further amplifier unit from the i-th measurement signal, the method further comprises the step of copying filter coefficients and status storage areas of the at least one digital filter of the i-th amplifier unit to the at least one digital filter of the further amplifier unit, and
after a step of feeding another measurement signal of the N measurement signals, which was previously fed to another amplifier unit of the at least N+1 amplifier units, to the i-th amplifier unit and before a step of outputting measurement values produced by the i-th amplifier unit from the other measurement signal, the method further comprises the step of copying filter coefficients and status storage areas of the at least one digital filter of the other amplifier unit to the at least one digital filter of the i-th amplifier unit.

2. The method according to claim 1, wherein j is greater than or equal to 1 and
the further amplifier unit is an (N+j)-th amplifier unit (107; 207) of the at least N+1 amplifier units,
the at least two i-th reference signals are used to calibrate the i-th amplifier unit (108; 208, 224), and
after the step of adjusting the i-th amplifier unit, the i-th measurement signal (111; 211, 225) is again fed to the i-th amplifier unit and the measurement values (116; 216, 226) produced by it are outputted.

3. The method according to claim 1, wherein j is greater than or equal to 1 and
for i = 1,
the further amplifier unit is an (N+j)-th amplifier unit (307) of the at least N+1 amplifier units, at least two (i+1)-th reference signals are used to calibrate the i-th amplifier unit (308), and after the step of adjusting the i-th amplifier unit, a measurement signal of the N measurement signals, which was previously fed to an (i+1)-th amplifier unit (324) of the at least N+1 amplifier units, is fed to the i-th amplifier unit and measurement values (316) produced by the i-th amplifier unit from said measurement signal are outputted,
for 1 < i < N
the further amplifier unit is an (i-1)-th amplifier unit of the at least N+1 amplifier units, at least two (i+1)-th reference signals are used to calibrate the i-th amplifier unit, and after the step of adjusting the i-th amplifier unit, a measurement signal of the N measurement signals, which was previously fed to an (i+1)-th amplifier unit of the at least N+1 amplifier units, is fed to the i-th amplifier unit and measurement values produced by the i-th amplifier unit from said measurement signal are outputted, and
for i = N
the further amplifier unit is an (i-1)-th amplifier unit (308) of the at least N+1 amplifier units, at least two (N+j)-th reference signals are used to calibrate the i-th amplifier unit (324), and after the step of adjusting the i-th amplifier unit, a measurement signal of the N measurement signals, which was previously fed to the (N+j)-th amplifier unit (307) of the at least N+1 amplifier units is fed to the i-th amplifier unit and measurement values (326) produced by the i-th amplifier unit from said measurement signal are outputted.

4. The method according to claim 1, wherein the measurement amplifier has at least 2 x N amplifier units and wherein
the further amplifier unit is an (i+N)-th amplifier unit of the at least 2 x N amplifier units,
the at least two i-th reference signals are used to calibrate the i-th amplifier unit, and
after the step of adjusting the i-th amplifier unit, the i-th measurement signal is again fed to the i-th amplifier unit and the measurement values (116; 216, 226) produced by it are outputted.

5. The method according to claim 1, wherein the amplifier units of the measurement amplifier each have at least one filter and wherein,
after the step of feeding (S6) the i-th measurement signal to the further amplifier unit and before the step of outputting (S7) measurement values produced by the further amplifier unit from the i-th measurement signal, the method further comprises the step of waiting until the at least one filter of the further amplifier unit has stabilised, and
after a step of feeding another measurement signal of the N measurement signals, which was previously fed to another amplifier unit of the at least N+1 amplifier units, to the i-th amplifier unit and before a step of outputting measurement values produced by the i-th amplifier unit from the other measurement signal, the method further comprises the step of waiting until the at least one filter of the i-th amplifier unit has stabilised.

6. The method according to claim 1, wherein
after the step of feeding (S6) the i-th measurement signal to the further amplifier unit and before the step of outputting (S7) measurement values produced by the further amplifier unit from the i-th measurement signal, the method further comprises the step of correcting a difference between the inherent errors of the i-th amplifier unit and the further amplifier unit, and
after a step of feeding another measurement signal of the N measurement signals, which was previously fed to another amplifier unit of the at least N+1 amplifier units, to the i-th amplifier unit and before a step of outputting measurement values produced by the i-th amplifier unit from the other measurement signal, the method further comprises the step of correcting a difference between the inherent errors of the other amplifier unit and the i-th amplifier unit.

7. A method according to any one of the preceding claims, wherein all the steps are cyclically repeated in order to automatically calibrate and if necessary to adjust the measurement amplifier at predetermined time intervals.

8. A measurement amplifier (103; 203; 303) for carrying out a method according to any one of the preceding claims, wherein the measurement amplifier has the following features:
the at least N+1 amplifier units (107, 108; 207, 208, 224; 307, 308, 324), each having the amplifier circuit (117, 120; 217, 220, 227; 317, 320, 327), the analogue-to-digital converter (118, 121; 218, 221, 228; 318, 321, 328) and the digital signal processing unit (119, 122; 219, 222, 229; 319, 322, 329) comprising the at least one digital filter;
at least N+1 switches, each of which is assigned to one of the N+1 amplifier units;
at least one reference signal generator (105, 106; 205, 206; 305, 306); and
at least one selection means (109; 209; 309), wherein
each amplifier unit of the N+1 amplifier units can be calibrated and adjusted with the aid of reference signals produced by the at least one reference signal generator,
one amplifier unit of the at least N+1 amplifier units can be connected in parallel with each of the other amplifier units, each amplifier unit of the at least N+1 amplifier units can be connected in parallel with each of the other amplifier units, or each amplifier unit of the at least N+1 amplifier units can be connected in parallel with precisely one other amplifier unit, wherein the respective switching can be carried out using respective switches of the at least N+1 switches, and
the at least one selection means is configured to output N measurement values corresponding to the N measurement signals,
**characterised in that,**
the measurement amplifier is configured to copy filter coefficients and status storage areas of the at least one digital filter of an output amplifier unit of the at least N+1 amplifier units, the measurement task of which is carried out by a target amplifier unit of the at least N+1 amplifier units, to the at least one digital filter of the target amplifier unit after feeding an i-th measurement signal of the N measurement signals to the target amplifier unit and before outputting measurement values produced by the target amplifier unit from the i-th measurement signal.

9. A measuring system (101; 201; 301) comprising a measurement amplifier (103; 203; 303) according to claim 8 and at least one measuring transducer (102; 202; 302) configured to feed the N measurement signals to the measurement amplifier.

## Revendications

1. Procédé d'étalonnage et de réglage ininterrompus d'un amplificateur de mesure (103; 203; 303) pour N signaux de mesure (111; 211, 225; 311, 325) qui comprend au moins N+1 dispositifs d'amplification (107, 108; 207, 208, 224; 307, 308, 324) ayant chacun un circuit d'amplification (117, 120; 217, 220, 227; 317, 320, 327), un convertisseur analogique-numérique (118, 121; 218, 221, 228; 318, 321, 328) et une unité de traitement de signal numérique (119, 122; 219, 222, 229; 319, 322, 329) avec au moins un filtre numérique, et qui est agencé de manière à délivrer N valeurs de mesure correspondant aux N signaux de mesure où N ≥ 1, et pour i = 1 jusqu'à N, les étapes suivantes sont effectuées:
fournir (S1) un i-ième signal de mesure des N signaux de mesure à un i-ième dispositif d'amplification desdits au moins N+1 dispositifs d'amplification;
délivrer (S2) des valeurs de mesure générées par le i-ième dispositif d'amplification à partir du i-ième signal de mesure;
fournir (S3) au moins deux i-ièmes signaux de référence (112, 113; 212, 213; 312, 313) à un autre dispositif d'amplification desdits au moins N+1 dispositifs d'amplification;
étalonner (S4) l'autre dispositif d'amplification à l'aide desdits au moins deux i-ièmes signaux de référence, dans lequel une erreur de point zéro et une erreur de gain de l'autre dispositif d'amplification sont déterminées;
régler (S5) l'autre dispositif d'amplification si au moins l'une des erreurs déterminées pour celui-ci se situe au-dessus d'une valeur de seuil prédéterminée pour cette erreur;
fournir (S6) le i-ième signal de mesure à l'autre dispositif d'amplification;
délivrer (S7) des valeurs de mesure générées par l'autre dispositif d'amplification à partir du i-ième signal de mesure;
fournir (S8) au moins deux signaux de référence au i-ième dispositif d'amplification;
étalonner (S9) le i-ième dispositif d'amplification à l'aide desdits au moins deux signaux de référence lui étant fournis, dans lequel une erreur de point zéro et une erreur de gain du i-ième dispositif d'amplification sont déterminées; et
régler (S10) le i-ième dispositif d'amplification si au moins l'une des erreurs déterminées pour celui-ci se situe au-dessus de la valeur de seuil prédéterminée pour cette erreur,
**caractérisé en ce que**
après l'étape consistant à fournir (S6) le i-ième signal de mesure à l'autre dispositif d'amplification, et avant l'étape consistant à délivrer (S7) des valeurs de mesure générées par l'autre dispositif d'amplification à partir du i-ième signal de mesure, une étape, qui consiste à copier des coefficients de filtre et des mémoires d'état dudit au moins un filtre numérique du i-ième dispositif d'amplification sur ledit au moins un filtre numérique de l'autre dispositif d'amplification, est effectuée, et
après une étape consistant à fournir, au i-ième dispositif d'amplification, un autre signal de mesure des N signaux de mesure qui est fourni jusqu'ici à un autre dispositif d'amplification desdits au moins N+1 dispositifs d'amplification, et avant une étape consistant à délivrer des valeurs de mesure générées par le i-ième dispositif d'amplification à partir de l'autre signal de mesure, une étape, qui consiste à copier des coefficients de filtre et des mémoires d'état dudit au moins un filtre numérique de l'autre dispositif d'amplification sur ledit au moins un filtre numérique du i-ième dispositif d'amplification, est effectuée.

2. Procédé selon la revendication 1, où j ≥ 1 et dans lequel
l'autre dispositif d'amplification est un (N+j)-ième dispositif d'amplification (107; 207) desdits au moins N+1 dispositifs d'amplification,
pour étalonner le i-ième dispositif d'amplification (108; 208, 224), lesdits au moins deux i-ièmes signaux de référence sont utilisés, et
après l'étape consistant à régler le i-ième dispositif d'amplification, de nouveau le i-ième signal de mesure (111; 211, 225) est fourni au i-ième dispositif d'amplification et les valeurs de mesure (116; 216, 226) qu'il génère sont délivrées.

3. Procédé selon la revendication 1, où j ≥ 1 et dans lequel
pour i = 1,
l'autre dispositif d'amplification est un (N+j)-ième dispositif d'amplification (307) desdits au moins N+1 dispositifs d'amplification, pour étalonner le i-ième dispositif d'amplification (308), au moins deux (i+1)-ièmes signaux de référence sont utilisés, et après l'étape consistant à régler le i-ième dispositif d'amplification, un signal de mesure des N signaux de mesure, qui est fourni jusqu'ici à un (i+1)-ième dispositif d'amplification (324) desdits au moins N+1 dispositifs d'amplification, est fourni au i-ième dispositif d'amplification, et des valeurs de mesure (316), qui sont générées par le i-ième dispositif d'amplification à partir de ce signal de mesure, sont délivrées,
pour 1 < i < N,
l'autre dispositif d'amplification est un (i-1)-ième dispositif d'amplification desdits au moins N+1 dispositifs d'amplification, pour étalonner le i-ième dispositif d'amplification, au moins deux (i+1)-ièmes signaux de référence sont utilisés, et après l'étape consistant à régler le i-ième dispositif d'amplification, un signal de mesure des N signaux de mesure, qui est fourni jusqu'ici à un (i+1)-ième dispositif d'amplification desdits au moins N+1 dispositifs d'amplification, est fourni au i-ième dispositif d'amplification, et des valeurs de mesure, qui sont générées par le i-ième dispositif d'amplification à partir de ce signal de mesure, sont délivrées, et
pour i = N,
l'autre dispositif d'amplification est un (i-1)-ième dispositif d'amplification (308) desdits au moins N+1 dispositifs d'amplification, pour étalonner le i-ième dispositif d'amplification (324), au moins deux (N+j)-ièmes signaux de référence sont utilisés, et après l'étape consistant à régler le i-ième dispositif d'amplification, un signal de mesure des N signaux de mesure, qui est fourni jusqu'ici au (N+j)-ième dispositif d'amplification (307) desdits au moins N+1 dispositifs d'amplification, est fourni au i-ième dispositif d'amplification, et des valeurs de mesure (326), qui sont générées par le i-ième dispositif d'amplification à partir de ce signal de mesure, sont délivrées.

4. Procédé selon la revendication 1, dans lequel l'amplificateur de mesure comprend au moins 2 × N dispositifs d'amplification, et dans lequel
l'autre dispositif d'amplification est un (i+N)-ième dispositif d'amplification desdits au moins 2 × N dispositifs d'amplification,
pour étalonner le i-ième dispositif d'amplification, lesdits au moins deux i-ièmes signaux de référence sont utilisés, et
après l'étape consistant à régler le i-ième dispositif d'amplification, de nouveau le i-ième signal de mesure est fourni au i-ième dispositif d'amplification et les valeurs de mesure qu'il génère sont délivrées.

5. Procédé selon la revendication 1, dans lequel les dispositifs d'amplification de l'amplificateur de mesure comprennent chacun au moins un filtre, et dans lequel
après l'étape consistant à fournir (S6) le i-ième signal de mesure à l'autre dispositif d'amplification, et avant l'étape consistant à délivrer (S7) des valeurs de mesure générées par l'autre dispositif d'amplification à partir du i-ième signal de mesure, il est attendu que ledit au moins un filtre de l'autre dispositif d'amplification soit en régime transitoire, et
après une étape consistant à fournir un autre signal de mesure des N signaux de mesure, qui est fourni jusqu'ici à un autre dispositif d'amplification desdits au moins N+1 dispositifs d'amplification, et avant une étape consistant à délivrer des valeurs de mesure générées par le i-ième dispositif d'amplification à partir de l'autre signal de mesure, il est attendu que ledit au moins un filtre du i-ième dispositif d'amplification soit en régime transitoire.

6. Procédé selon la revendication 1, dans lequel
après l'étape consistant à fournir (S6) le i-ième signal de mesure à l'autre dispositif d'amplification et avant l'étape consistant à délivrer (S7) des valeurs de mesure générées par l'autre dispositif d'amplification à partir du i-ième signal de mesure, une étape consistant à corriger une différence des erreurs intrinsèques du i-ième dispositif d'amplification et de l'autre dispositif d'amplification est effectuée, et
après une étape consistant à fournir un autre signal de mesure des N signaux de mesure, qui est fourni jusqu'ici à un autre dispositif d'amplification desdits au moins N+1 dispositifs d'amplification, et avant une étape consistant à délivrer des valeurs de mesure générées par le i-ième dispositif d'amplification à partir de l'autre signal de mesure, une étape consistant à corriger une différence des erreurs intrinsèques de l'autre dispositif d'amplification et du i-ième dispositif d'amplification est effectuée.

7. Procédé selon l'une quelconque des revendications précédentes, dans lequel toutes les étapes sont répétées de manière cyclique pour étalonner automatiquement l'amplificateur de mesure à des intervalles de temps prédéterminés et le régler si nécessaire.

8. Amplificateur de mesure (103; 203; 303) pour mettre en oeuvre un procédé selon l'une quelconque des revendications précédentes, dans lequel l'amplificateur de mesure comprend les caractéristiques suivantes:
lesdits au moins N+1 dispositifs d'amplification (107, 108; 207, 208, 224; 307, 308, 324), chacun comprenant le circuit d'amplification (117, 120; 217, 220, 227; 317, 320, 327), le convertisseur analogique-numérique (118, 121; 218, 221, 228; 318, 321, 328) et l'unité de traitement de signal numérique (119, 122; 219, 222, 229; 319, 322, 329) avec ledit au moins un filtre numérique;
au moins N+1 commutateurs, lesquels sont respectivement associés à l'un des N+1 dispositifs d'amplification;
au moins un dispositif de génération de signal de référence (105, 106; 205, 206; 305, 306); et
au moins un dispositif de sélection (109; 209; 309), dans lequel
chaque dispositif d'amplification des N+1 dispositifs d'amplification peut être étalonné à l'aide de signaux de référence, qui sont générés par ledit au moins un dispositif de génération de signal de référence, et réglé,
un dispositif d'amplification desdits au moins N+1 dispositifs d'amplification peut être connecté en parallèle à chacun des autres dispositifs d'amplification, chaque dispositif d'amplification desdits au moins N+1 dispositifs d'amplification peut être respectivement connecté en parallèle à chacun des autres dispositifs d'amplification ou chaque dispositif d'amplification desdits au moins N+1 dispositifs d'amplification peut être connecté en parallèle à exactement un autre dispositif d'amplification, la commutation respective pouvant être mise en œuvre par l'intermédiaire de commutateurs correspondants desdits au moins N+1 commutateurs, et
ledit au moins un dispositif de sélection est configuré pour délivrer N valeurs de mesure qui correspondent aux N signaux de mesure,
**caractérisé en ce que**
l'amplificateur de mesure est configuré pour copier des coefficients de filtre et des mémoires d'état dudit au moins un filtre numérique d'un dispositif d'amplification de sortie desdits au moins N+1 dispositifs d'amplification, dont la tâche de mesure est prise en charge par un dispositif d'amplification cible desdits au moins N+1 dispositifs d'amplification, sur ledit au moins un filtre numérique du dispositif d'amplification cible, après qu'un i-ième signal de mesure des N signaux de mesure a été fourni au dispositif d'amplification cible et avant que des valeurs de mesure générées par le dispositif d'amplification cible à partir du i-ième signal de mesure aient été délivrées.

9. Système de mesure (101; 201; 301) avec un amplificateur de mesure (103; 203; 303) selon la revendication 8 et au moins un capteur de mesure (102; 202; 302), lequel est configuré pour fournir les N signaux de mesure à l'amplificateur de mesure.
